# EUROPEAN PATENT APPLICATION

(11) **EP 4 580 329 A1**
(43) Date of publication of application: **02.07.2025**
(21) Application number: 23864424.9
(22) Date of filing: 28.06.2023
(51) Int. Cl.: H10B 41/42, H10B 41/40, G11C 11/22

(54) **FERROELECTRIC MEMORY, THREE-DIMENSIONAL INTEGRATED CIRCUIT, AND ELECTRONIC DEVICE**

(30) Priority: 14.09.2022 CN 202211115561
(71) Applicant: Huawei Technologies Co., Ltd., Shenzhen, Guangdong 518129 (CN)
(72) Inventor: HUANG, Kailiang, Shenzhen, Guangdong 518129 (CN); JING, Weiliang, Shenzhen, Guangdong 518129 (CN); YIN, Shihui, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Maiwald GmbH
(86) International application number: PCT/CN2023/103240
(87) International publication number: WO 2024/055685

(57) **Abstract**

This application provides a ferroelectric memory, a three-dimensional integrated circuit, and an electronic device, and relates to the field of semiconductor chip technologies, to improve an anti-interference capability of a capacitor. The ferroelectric memory includes a capacitor. The capacitor includes a first stacked layer, a first conductive pillar, a second conductive pillar, a first ferroelectric layer, and a second ferroelectric layer. The first stacked layer includes a first conductive portion and a second conductive portion that are connected. The first conductive pillar penetrates the first conductive portion, and the second conductive pillar penetrates the second conductive portion. The first ferroelectric layer penetrates the first conductive portion and is disposed around the first conductive pillar, and the second ferroelectric layer penetrates the second conductive portion and is disposed around the second conductive pillar. The capacitor includes a first capacitor and a second capacitor that are disposed in series, the first capacitor includes the first conductive pillar, the first ferroelectric layer, and the first conductive portion, and the second capacitor includes the second conductive pillar, the second ferroelectric layer, and the second conductive portion. The ferroelectric memory can be used in the three-dimensional integrated circuit to read and write data.

## Description

This application claims priority to Chinese Patent Application No. 202211115561.7, filed with the China National Intellectual Property Administration on September 14, 2022 and entitled "FERROELECTRIC MEMORY, THREE-DIMENSIONAL INTEGRATED CIRCUIT, AND ELECTRONIC DEVICE", which is incorporated herein by reference in its entirety.

### TECHNICAL FIELD

This application relates to the field of semiconductor chip technologies, and in particular, to a ferroelectric memory, a three-dimensional integrated circuit, and an electronic device.

### BACKGROUND

With the development of semiconductor chip technologies, two-dimensional integrated circuits (2D Integrated Circuit, 2D IC) used as systems on chips (System On Chip, SOC) can no longer meet people's requirements on functions, sizes and energy consumption of chips.

Currently, three-dimensional stacking (3D stacking) is performed on a plurality of chips to form a three-dimensional integrated circuit (3D Integrated Circuit, 3D IC), which can improve bandwidth and energy efficiency of interconnection between the plurality of chips. Therefore, the three-dimensional integrated circuit gradually attracts attention in the field.

In the three-dimensional integrated circuit, to ensure power integrity (Power Integrity, PI) of a chip, a decoupling capacitor (Decoupling Capacitor, Decap) needs to be disposed in a power distribution network (Power Distribution Network, PDN) of the chip, so that the power distribution network can provide a stable power supply. However, as operating time increases, an anti-interference capability of the decoupling capacitor deteriorates, and consequently, a capacitance value of the decoupling capacitor changes. As a result, the power distribution network cannot provide the stable power supply.

### SUMMARY

Embodiments of this application provide a ferroelectric memory, a three-dimensional integrated circuit, and an electronic device, to improve an anti-interference capability of a decoupling capacitor in a chip.

To achieve the foregoing objectives, the following technical solutions are used in embodiments of this application.

According to a first aspect, a ferroelectric memory is provided. The ferroelectric memory may be a ferroelectric random access memory (Ferroelectric Random Access Memory, FeRAM), or may be a ferroelectric field effect transistor (Ferroelectric Field Effect Transistor, FeFET) memory, and can read and write data.

The ferroelectric memory includes an array region and a routing region. The ferroelectric memory includes a memory array disposed in the array region and a capacitor disposed in the routing region. The capacitor includes a first stacked layer, a first conductive pillar, a second conductive pillar, a first ferroelectric layer, and a second ferroelectric layer. The first stacked layer includes a plurality of conducting layers and a plurality of first dielectric layers that are alternately stacked. The plurality of conducting layers include a first conductive portion and a second conductive portion that are connected. The first conductive pillar penetrates the first conductive portion, and the second conductive pillar penetrates the second conductive portion. The first ferroelectric layer and the second ferroelectric layer are of cylindrical structures, the first ferroelectric layer penetrates the first conductive portion and is disposed around the first conductive pillar, and the second ferroelectric layer penetrates the second conductive portion and is disposed around the second conductive pillar. The capacitor includes a first capacitor and a second capacitor that are disposed in series, the first capacitor includes the first conductive pillar, the first ferroelectric layer, and the first conductive portion, and the second capacitor includes the second conductive pillar, the second ferroelectric layer, and the second conductive portion.

In the ferroelectric memory provided in the foregoing embodiment of this application, the first conductive pillar is used to penetrate the first conductive portion of the conducting layer, and the first ferroelectric layer is disposed around the first conductive pillar, to separate the first conductive pillar from the first conductive portion. The first conductive pillar, the first ferroelectric layer, and the first conductive portion form the first capacitor, and the first conductive pillar and the first conductive portion are used as two poles of the first capacitor.

In addition, the second conductive pillar is used to penetrate the second conductive portion of the conducting layer, and the second ferroelectric layer is disposed around the second conductive pillar, to separate the second conductive pillar from the second conductive portion. The second conductive pillar, the second ferroelectric layer, and the second conductive portion form the second capacitor, and the second conductive pillar and the second conductive portion are used as two poles of the second capacitor.

One electrode of the first capacitor is electrically connected to one electrode of the second capacitor by connecting the first conductive portion to the second conductive portion, so that the first capacitor and the second capacitor are disposed in series. According to a series voltage division principle, an electric potential difference between two ends of each capacitor can be reduced, to reduce a probability of polarization reversal at the ferroelectric layer of the capacitor, ensure a stable capacitance value of the capacitor, and improve an anti-interference capability of the capacitor.

In some embodiments, each conducting layer includes at least one first conductive portion and at least one second conductive portion, and the first conductive portion and the second conductive portion that are connected are located at a same conducting layer, so that the first conductive portion is connected to the second conductive portion.

In some embodiments, each conducting layer includes one first conductive portion and one second conductive portion, and the first conductive portion is connected to the second conductive portion. The first conductive portion and the second conductive portion are arranged in a first direction, and the first direction is parallel to a bottom surface of the first stacked layer. The plurality of first conductive pillars penetrate the first conductive portion, which is equivalent to a plurality of first capacitors being disposed in parallel. The plurality of second conductive pillars penetrate the second conductive portion, which is equivalent to a plurality of second capacitors being disposed in parallel. The first conductive portion and the second conductive portion that are at the same conducting layer are connected, so that the plurality of first capacitors connected in parallel are connected in series to the plurality of second capacitors connected in parallel to form a third capacitor.

In the foregoing embodiment, a total capacitance value of the plurality of first capacitors connected in parallel is greater than a capacitance value of one first capacitor, and a total capacitance value of the plurality of second capacitors connected in parallel is greater than a capacitance value of one second capacitor. A capacitance value of the third capacitor can be increased, thereby increasing a total capacitance value of the capacitor.

In addition, the plurality of first capacitors connected in parallel are connected in series to the plurality of second capacitors connected in parallel to form the third capacitor, thereby reducing an electric potential difference between two ends of the plurality of capacitors (the first capacitors or the second capacitors) connected in parallel, and reducing the electric potential difference between the two ends of each capacitor, to reduce the probability of the polarization reversal at the ferroelectric layer of the capacitor, ensure the stable capacitance value of the capacitor, and improve the anti-interference capability of the capacitor.

In some embodiments, the capacitor further includes a first interconnection electrode and a second interconnection electrode, and the first interconnection electrode and the second interconnection electrode are of planar structures. The first interconnection electrode and the second interconnection electrode are arranged in the first direction. The first interconnection electrode is electrically connected to end portions of the plurality of first conductive pillars, to transmit an electrical signal to the plurality of first conductive pillars via the first interconnection electrode. The second interconnection electrode is electrically connected to end portions of the plurality of second conductive pillars, to transmit an electrical signal to the plurality of second conductive pillars via the second interconnection electrode.

In some embodiments, the plurality of first conductive pillars are arranged in an array, and/or the plurality of second conductive pillars are arranged in an array. This can improve uniformity of arrangement of the plurality of first conductive pillars and the plurality of second conductive pillars, and help reduce signal interference between the plurality of capacitors.

In some embodiments, the capacitor further includes a first interconnection electrode and a second interconnection electrode, and the first interconnection electrode and the second interconnection electrode are of comb structures. The first interconnection electrode and the second interconnection electrode are arranged in the first direction, the first interconnection electrode includes a plurality of first interconnection lines, and the second interconnection electrode includes a plurality of second interconnection lines.

The first interconnection line and the second interconnection line extend in the first direction, the plurality of first interconnection lines are electrically connected to end portions of the plurality of first conductive pillars, and the plurality of first interconnection lines are connected to one side of the first stacked layer in the first direction. The plurality of second interconnection lines are electrically connected to end portions of the plurality of second conductive pillars, and the plurality of second interconnection lines are connected to the other side of the first stacked layer in the first direction.

Alternatively, the first interconnection line and the second interconnection line extend in a second direction, the plurality of first interconnection lines are electrically connected to end portions of the plurality of first conductive pillars, and the plurality of first interconnection lines are connected to one side of the first stacked layer in the second direction. The plurality of second interconnection lines are electrically connected to end portions of the plurality of second conductive pillars, the plurality of second interconnection lines are connected to one side of the first stacked layer in the second direction, and the second direction is parallel to the bottom surface of the first stacked layer and intersects with the first direction.

In some embodiments, each conducting layer includes a plurality of first conductive portions and a plurality of second conductive portions, and the plurality of first conductive portions are connected to the plurality of second conductive portions. The first conductive portions and the second conductive portions are alternately arranged in a first direction, and the first direction is parallel to a bottom surface of the first stacked layer. The plurality of first conductive pillars penetrate the first conductive portions, and the plurality of second conductive pillars penetrate the second conductive portions.

In the foregoing embodiment, the plurality of first conductive pillars penetrate the first conductive portions, which is equivalent to a plurality of first capacitors being disposed in parallel. The plurality of second conductive pillars penetrate the second conductive portions, which is equivalent to a plurality of second capacitors being disposed in parallel. A plurality of first conductive portions and a plurality of second conductive portions that are at a same conducting layer are connected, so that the plurality of first capacitors connected in parallel are connected in series to the plurality of second capacitors connected in parallel to form a third capacitor. The electric potential difference between the two ends of each capacitor can be reduced by connecting the capacitors in series, to reduce the probability of the polarization reversal at the ferroelectric layer of the capacitor, ensure the stable capacitance value of the capacitor, and improve the anti-interference capability of the capacitor.

In some embodiments, the capacitor further includes a first interconnection electrode and a second interconnection electrode, and the first interconnection electrode and the second interconnection electrode are of comb structures. The first interconnection electrode includes a plurality of first interconnection lines, the second interconnection electrode includes a plurality of second interconnection lines, the plurality of first interconnection lines and the plurality of second interconnection lines are arranged in the first direction, and the first interconnection lines and the second interconnection lines extend in a second direction.

The plurality of first interconnection lines are electrically connected to end portions of the plurality of first conductive pillars, the plurality of first interconnection lines are connected to one side of the first stacked layer in the second direction, and an electric signal is transmitted to the plurality of first conductive pillars via the plurality of first interconnection lines of the first interconnection electrode. The plurality of second interconnection lines are electrically connected to end portions of the plurality of second conductive pillars, the plurality of second interconnection lines are connected to the other side of the first stacked layer in the second direction, and an electric signal is transmitted to the plurality of second conductive pillars via the plurality of second interconnection lines of the second interconnection electrode.

In some embodiments, the plurality of first interconnection lines and the plurality of second interconnection lines are alternately arranged in the first direction. Alternatively, there is no second interconnection line or there are a plurality of second interconnection lines disposed between two adjacent first interconnection lines, and there is no first interconnection line or there are a plurality of first interconnection lines disposed between two adjacent second interconnection lines.

In some embodiments, there are a plurality of rows of the plurality of first conductive pillars, and one first interconnection line is electrically connected to one row of first conductive pillars, to transmit the electrical signal to the row of first conductive pillars via the first interconnection line; and/or there are a plurality of rows of the plurality of second conductive pillars, and one second interconnection line is electrically connected to one row of second conductive pillars, to transmit the electrical signal to the row of second conductive pillars via the second interconnection line.

In some embodiments, the first conductive portion and the second conductive portion that are located at the same conducting layer are integrally disposed, to connect the first conductive portion to the second conductive portion.

In some embodiments, each conducting layer includes a plurality of spaced-apart conducting blocks, and one conducting block includes one first conductive portion and one second conductive portion that are connected. The plurality of first conductive pillars penetrate the first conductive portion of the conducting block, which is equivalent to a plurality of first capacitors being disposed in parallel. The plurality of second conductive pillars penetrate the second conductive portion of the conducting block, which is equivalent to a plurality of second capacitors being disposed in parallel. A first conductive portion and a second conductive portion that are of a same conducting block are connected, so that the plurality of first capacitors connected in parallel are connected in series to the plurality of second capacitors connected in parallel to form a third capacitor.

In two adjacent conducting blocks, the plurality of second conductive pillars that penetrate one conducting block are electrically connected to the plurality of first conductive pillars that penetrate the other conducting block, so that third capacitors of the adjacent conducting blocks are connected in series to form a fourth capacitor.

In the foregoing embodiment, a total capacitance value of the plurality of first capacitors connected in parallel is greater than a capacitance value of one first capacitor, and a total capacitance value of the plurality of second capacitors connected in parallel is greater than a capacitance value of one second capacitor. A capacitance value of the third capacitor can be increased, and a capacitance value of the fourth capacitor can be increased, thereby increasing a total capacitance value of the capacitor.

In addition, the plurality of first capacitors connected in parallel are connected in series to the plurality of second capacitors connected in parallel to form the third capacitor, and the third capacitors of the adjacent conducting blocks are connected in series to form the fourth capacitor, to increase a quantity of capacitors connected in series, thereby further reducing the electric potential difference between the two ends of each capacitor, and reducing the probability of the polarization reversal at the ferroelectric layer of the capacitor, ensure the stable capacitance value of the capacitor, and improve the anti-interference capability of the capacitor.

In some embodiments, the capacitor further includes a second dielectric layer that penetrates the first stacked layer and separates the two adjacent conducting blocks. In other words, second dielectric layers divide the conducting layer into a plurality of conducting blocks.

In some embodiments, each conducting layer includes a 1^{st} conducting block to an n^{th} conducting block that are sequentially disposed, n≥2, and n is a positive integer. The capacitor further includes one first interconnection electrode, at least one second interconnection electrode, and one third interconnection electrode. The first interconnection electrode is electrically connected to a first conductive pillar that penetrates the 1^{st} conducting block. The second interconnection electrode is electrically connected to a second conductive pillar that penetrates an i^{th} conducting block and a first conductive pillar that penetrates an (i+1)^{th} conducting block, i=1 to n-1, and i is a positive integer. The third interconnection electrode is electrically connected to a second conductive pillar that penetrates the n^{th} conducting block.

In the foregoing embodiment, the first interconnection electrode and the third interconnection electrode receive an external electrical signal, and transmit the electrical signal to the fourth capacitor.

In some embodiments, the plurality of conducting layers include a plurality of first conductive portions and a plurality of second conductive portions, and the plurality of second conductive portions are located on a side that is of the plurality of first conductive portions and that is away from a bottom surface of the first stacked layer. The plurality of first conductive pillars penetrate the plurality of first conductive portions, which is equivalent to a plurality of first capacitors being disposed in parallel. The plurality of second conductive pillars penetrate the plurality of second conductive portions, which is equivalent to a plurality of second capacitors being disposed in parallel.

The capacitor further includes a third conductive pillar that penetrates the first stacked layer, and the third conductive pillar is electrically connected to the plurality of first conductive portions and the plurality of second conductive portions, so that the plurality of first capacitors connected in parallel are connected in series to the plurality of second capacitors connected in parallel.

In the foregoing embodiment, a total capacitance value of the plurality of first capacitors connected in parallel is greater than a capacitance value of one first capacitor, and a total capacitance value of the plurality of second capacitors connected in parallel is greater than a capacitance value of one second capacitor. A total capacitance value of the capacitor can be increased.

In addition, the plurality of first capacitors connected in parallel are connected in series to the plurality of second capacitors connected in parallel, thereby reducing an electric potential difference between two ends of the plurality of capacitors (the first capacitors or the second capacitors) connected in parallel, and reducing the electric potential difference between the two ends of each capacitor, to reduce the probability of the polarization reversal at the ferroelectric layer of the capacitor, ensure the stable capacitance value of the capacitor, and improve the anti-interference capability of the capacitor.

In some embodiments, the capacitor further includes a first interconnection electrode and a second interconnection electrode. The first interconnection electrode is disposed on a side that is of the bottom surface of the first stacked layer and that is away from the plurality of first conductive portions, and is electrically connected to end portions of the plurality of first conductive pillars, to transmit an electrical signal to the plurality of first conductive pillars via the first interconnection electrode. The second interconnection electrode is disposed on a side that is of the plurality of second conductive portions and that is away from the bottom surface of the first stacked layer, and is electrically connected to end portions of the plurality of second conductive pillars, to transmit an electrical signal to the plurality of second conductive pillars via the second interconnection electrode.

In some embodiments, materials of the conducting layer, the first conductive pillar, and the second conductive pillar include at least one of Ti, Au, W, Mo, Al, Cu, Ru, Ag, TiN, and ITO.

In some embodiments, materials of the first ferroelectric layer and/or the second ferroelectric layer include at least one of ZrO₂, HfO₂, HfAlO, HfSiO, HfZrO, HfLaO, and HfYO.

In some embodiments, the first dielectric layer is of a single-layer structure or a stacked-layer structure. A material of the first dielectric layer includes at least one of SiO₂, Al₂O₃, HfO₂, ZrO₂, TiO₂, Y₂O₃, and Si₃N₄.

In some embodiments, the memory array includes a second stacked layer, and the second stacked layer includes a plurality of memory cells arranged in an array.

The second stacked layer includes third dielectric layers and gate layers that are alternately disposed, the plurality of first dielectric layers of the first stacked layer one-to-one correspond to a plurality of third dielectric layers of the second stacked layer, and the first dielectric layer and the third dielectric layer that correspond to each other have a same material and are disposed at a same layer. The plurality of conducting layers of the first stacked layer one-to-one correspond to a plurality of gate layers of the second stacked layer, and the conducting layer and the gate layer that correspond to each other have a same material, are disposed at a same layer, and are insulated from each other.

According to a second aspect, a preparation method for a ferroelectric memory is provided. The method includes: forming a first stacked layer, where the first stacked layer includes a plurality of conducting layers and a plurality of first dielectric layers that are alternately stacked, and the plurality of conducting layers include a first conductive portion and a second conductive portion that are connected; forming a first contact hole that penetrates the first conductive portion and a second contact hole that penetrates the second conductive portion; forming a first ferroelectric layer on a sidewall of the first contact hole, and forming a second ferroelectric layer on a sidewall of the second contact hole; and forming a first conductive pillar on an inner side of the first ferroelectric layer, and forming a second conductive pillar on an inner side of the second ferroelectric layer.

According to the preparation method provided in the foregoing embodiment of this application, the first stacked layer is first formed. The first stacked layer includes the plurality of conducting layers and the plurality of first dielectric layers that are alternately stacked, and one conducting layer includes the first conductive portion and the second conductive portion that are connected. Then, the first contact hole that penetrates the first conductive portion and the second contact hole that penetrates the second conductive portion are formed. The first ferroelectric layer and the first conductive pillar are formed on the sidewall of the first contact hole, and the second ferroelectric layer and the second conductive pillar are formed on the sidewall of the second contact hole.

The first conductive pillar, the first ferroelectric layer, and the first conductive portion form a first capacitor, and the first conductive pillar and the first conductive portion are used as two poles of the first capacitor. The second conductive pillar, the second ferroelectric layer, and the second conductive portion form a second capacitor, and the second conductive pillar and the second conductive portion are used as two poles of the second capacitor. One electrode of the first capacitor is electrically connected to one electrode of the second capacitor by connecting the first conductive portion to the second conductive portion, so that the first capacitor and the second capacitor are disposed in series. An electric potential difference between two ends of each capacitor can be reduced, to reduce a probability of polarization reversal at the ferroelectric layer of the capacitor, ensure a stable capacitance value of the capacitor, and improve an anti-interference capability of the capacitor.

In some embodiments, after the forming a first conductive pillar and a second conductive pillar, the method further includes: forming a first interconnection electrode and a second interconnection electrode. The first interconnection electrode is electrically connected to end portions of the plurality of first conductive pillars, to transmit an electrical signal to the plurality of first conductive pillars. The second interconnection electrode is electrically connected to end portions of the plurality of second conductive pillars, to transmit an electrical signal to the plurality of second conductive pillars.

In some embodiments, after the forming a first stacked layer, the method further includes: forming at least one isolation trench that penetrates the first stacked layer, where the at least one isolation trench separates the conducting layer into a plurality of conducting blocks, one conducting block includes one first conductive portion and one second conductive portion, and the first conductive portion is connected to the second conductive portion; and forming a second dielectric layer in the isolation trench.

In the foregoing embodiment, the first stacked layer is etched to form the isolation trench that penetrates the first stacked layer, and second dielectric layers are formed in the isolation trench to divide the conducting layer into the plurality of conducting blocks, to increase a quantity of capacitors connected in series. The electric potential difference between the two ends of each capacitor can be further reduced, to reduce the probability of the polarization reversal at the ferroelectric layer of the capacitor, ensure the stable capacitance value of the capacitor, and improve the anti-interference capability of the capacitor.

In some embodiments, each conducting layer includes a 1^{st} conducting block to an n^{th} conducting block that are sequentially disposed, n≥2, and n is a positive integer.

After the forming a first conductive pillar and a second conductive pillar, the method further includes: forming one first interconnection electrode, at least one second interconnection electrode, and one third interconnection electrode. The first interconnection electrode is electrically connected to a first conductive pillar that penetrates the 1^{st} conducting block. The second interconnection electrode is electrically connected to a second conductive pillar that penetrates an i^{th} conducting block and a first conductive pillar that penetrates an (i+1)^{th} conducting block, i=1 to n-1, and i is a positive integer. The third interconnection electrode is electrically connected to a second conductive pillar that penetrates the n^{th} conducting block.

In some embodiments, the ferroelectric memory includes an array region and a routing region. A second stacked layer is synchronously formed in the array region in a process of forming the first stacked layer in the routing region.

According to a third aspect, a preparation method for a ferroelectric memory is further provided. The preparation method includes: forming a first stacked sublayer, where the first stacked sublayer includes a plurality of first conductive portions and a plurality of first dielectric layers that are alternately stacked; forming a first contact hole that penetrates the plurality of first conductive portions; forming a first ferroelectric layer on a sidewall of the first contact hole; forming a first conductive pillar on an inner side of the first ferroelectric layer; forming an insulation layer, where the insulation layer covers the first stacked sublayer, the first ferroelectric layer, and the first conductive pillar; forming a second stacked sublayer on a side that is of the insulation layer and that is away from the first stacked sublayer, where the second stacked sublayer includes a plurality of second conductive portions and a plurality of first dielectric layers that are alternately stacked; forming a second contact hole that penetrates the plurality of second conductive portions; forming a second ferroelectric layer on a sidewall of the second contact hole; forming a second conductive pillar on an inner side of the second ferroelectric layer; and forming a third conductive pillar, where the third conductive pillar penetrates the second stacked sublayer, the insulation layer, and the first stacked sublayer, and is electrically connected to the plurality of first conductive portions and the plurality of second conductive portions.

According to the preparation method provided in the foregoing embodiment of this application, the first stacked sublayer is first formed. The first stacked sublayer includes the plurality of first conductive portions and the plurality of first dielectric layers that are alternately stacked. Then, the first contact hole that penetrates the plurality of first conductive portions is formed, and the first ferroelectric layer and the first conductive pillar are formed on the sidewall of the first contact hole.

The second stacked sublayer is formed above the first stacked sublayer. The second stacked sublayer includes the plurality of second conductive portions and the plurality of first dielectric layers that are alternately stacked. Then, the second contact hole that penetrates the plurality of second conductive portions is formed, and the second ferroelectric layer and the second conductive pillar are formed on the sidewall of the second contact hole.

Finally, the third conductive pillar that penetrates the second stacked sublayer and the first stacked sublayer is formed, and is electrically connected to the plurality of first conductive portions and the plurality of second conductive portions, so that a plurality of first capacitors connected in parallel are connected in series to a plurality of second capacitors connected in parallel. An electric potential difference between two ends of each capacitor can be reduced, to reduce a probability of polarization reversal at a ferroelectric layer of the capacitor, ensure a stable capacitance value of the capacitor, and improve an anti-interference capability of the capacitor.

According to a fourth aspect, a three-dimensional integrated circuit is provided. The three-dimensional integrated circuit includes the ferroelectric memory according to any one of the foregoing embodiments and a processor chip. The processor chip is stacked with the ferroelectric memory, and is electrically connected to the ferroelectric memory.

According to a fifth aspect, an electronic device is provided. The electronic device is, for example, a consumer electronic product, a home electronic product, a vehicle-mounted electronic product, a financial terminal product, or a communication electronic product. The electronic device includes a circuit board, and the ferroelectric memory or the three-dimensional integrated circuit according to any one of the foregoing embodiments. The ferroelectric memory or the three-dimensional integrated circuit is disposed on the circuit board, and is electrically connected to the circuit.

It may be understood that, for beneficial effect that can be achieved by the three-dimensional integrated circuit and the electronic device provided in the foregoing embodiments of this application, refer to the foregoing beneficial effect of the ferroelectric memory. Details are not described herein again.

### BRIEF DESCRIPTION OF DRAWINGS

To describe technical solutions in this application more clearly, the following briefly describes accompanying drawings for describing some embodiments of this application. It is apparent that the accompanying drawings in the following description are merely accompanying drawings in some embodiments of this application. For a person of ordinary skill in the art, other drawings may also be derived from these drawings. In addition, the accompanying drawings in the following description may be considered as diagrams, and are not intended to limit an actual size of a product, an actual procedure of a method, an actual time sequence of a signal, and the like in embodiments of this application.
FIG. 1 is a diagram of an architecture of an electronic device according to some embodiments;
FIG. 2 is an exploded view of an electronic device according to some embodiments;
FIG. 3 is a diagram of a structure of a three-dimensional integrated circuit according to some embodiments;
FIG. 4 is a top view of a ferroelectric memory according to some embodiments;
FIG. 5 is a diagram of an architecture of a memory array of a ferroelectric memory according to some embodiments;
FIG. 6 is a diagram of a structure of a decoupling capacitor in a related technology;
FIG. 7 is a diagram of an electric hysteresis loop of a ferroelectric material in a ferroelectric capacitor;
FIG. 8 is a curve diagram of relationships between capacitance values of a ferroelectric capacitor before and after polarization reversal occurs and an electric potential difference between two poles of the ferroelectric capacitor;
FIG. 9 is a diagram of a structure of a capacitor according to some embodiments;
FIG. 10 is a top view of the capacitor in FIG. 9;
FIG. 11 is a cross-sectional view of the capacitor in FIG. 10 along a section line A-A';
FIG. 12 is an equivalent circuit schematic of the capacitor in FIG. 11;
FIG. 13 is a partially enlarged view of the capacitor in FIG. 11 at M;
FIG. 14 is an equivalent circuit schematic of the capacitor in FIG. 13;
FIG. 15 is a top view of another capacitor according to some embodiments;
FIG. 16 and FIG. 17 are top views of another capacitor according to some embodiments;
FIG. 18 is a top view of another capacitor according to some embodiments;
FIG. 19 is an equivalent circuit schematic of the capacitor in FIG. 18;
FIG. 20 is a top view of still another capacitor according to some embodiments;
FIG. 21 is an equivalent circuit schematic of the capacitor in FIG. 20;
FIG. 22A to FIG. 22E are diagrams of steps for preparing a capacitor according to some embodiments;
FIG. 23 is a top view of still another capacitor according to some embodiments;
FIG. 24 is a cross-sectional view of the capacitor in FIG. 23 along a section line B-B';
FIG. 25 is an equivalent circuit schematic of the capacitor in FIG. 24;
FIG. 26A to FIG. 26G are diagrams of steps for preparing another capacitor according to some embodiments;
FIG. 27 is a cross-sectional view of still another capacitor according to some embodiments;
FIG. 28 is an equivalent circuit schematic of the capacitor in FIG. 27; and
FIG. 29A to FIG. 29K are diagrams of steps for preparing still another capacitor according to some embodiments.

### DESCRIPTION OF EMBODIMENTS

The following clearly and completely describes technical solutions in some embodiments of this application with reference to accompanying drawings. It is clear that the described embodiments are merely some rather than all of embodiments of this application. All other embodiments obtained by a person of ordinary skill in the art based on embodiments of this application fall within the protection scope of this application.

In the descriptions of this application, it should be understood that directions or location relationships indicated by the terms such as "center", "up", "down", "front", "rear", "left", "right", "vertical", "horizontal", "top", "bottom", "inside", and "outside" are based on the directions or the location relationships shown in the accompanying drawings, and are merely intended to describe this application and simplify the descriptions, but not intended to indicate or imply that an indicated apparatus or component shall have a specific direction or be formed and operated in a specific direction, and therefore cannot be understood as a limitation on this application.

Unless otherwise required by the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or features related to embodiments or examples are included in at least one embodiment or example of this application. The foregoing schematic representations of the terms do not necessarily refer to a same embodiment or example. Further, the particular feature, structure, material, or characteristic may be included in any one or more embodiments or examples in any appropriate manner.

In the following description, the terms "first" and "second" are merely intended for a purpose of description, and shall not be understood as indicating or implying relative importance or implying a quantity of indicated technical features. Therefore, a feature limited by "first" or "second" may explicitly or implicitly include one or more features. In the description of embodiments of this application, "a plurality of" means two or more than two unless otherwise specified.

In the description of some embodiments, expressions of "connected" and extensions thereof may be used. For example, when some embodiments are described, the term "connection" may be used to indicate that two or more components are in direct physical contact or electrical contact with each other.

"At least one of A, B, and C" includes the following combinations of A, B, and C: only A, only B, only C, a combination of A and B, a combination of A and C, a combination of B and C, and a combination of A, B, and C.

"A and/or B" includes the following three combinations: only A, only B, and a combination of A and B.

The use of "configured to" in this specification implies an open and inclusive language, and does not exclude a device that is applicable to or configured to perform an additional task or step.

In addition, the use of "based on" means openness and inclusiveness, since processes, steps, calculation, or other actions "based on" one or more of conditions or values may be based in practice on additional conditions or values outside the described values.

In the content of this application, the meanings of "on", "above", and "on the top of" should be interpreted in a broadest manner, so that "on" means not only "directly on something", but also includes the meaning of "on something" with an intermediate feature or layer between associated objects, and "above" or "on the top of" not only means "above" or "on the top of" something, but also includes the meaning of being "above" or "on the top of" something (that is, directly on something) without the intermediate feature or layer between the associated objects.

In content of this application, "same layer" refers to a layer structure formed by using a same film forming process to form a film layer for forming a specific pattern and then by using a same mask and by using a same pattern forming process. Based on different particular patterns, a patterning process may include a plurality of exposure, development, or etching processes. Moreover, the particular patterns in the formed layer structure may be continuous or discontinuous, and these particular patterns may also have different heights or different thicknesses.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

Some embodiments of this application provide an electronic device. The electronic device may be different types of user equipment or terminal devices such as a mobile phone, a tablet computer, a personal digital assistant (Personal Digital Assistant, PDA), a television, or an intelligent wearable product (for example, a smartwatch or a smart band), a virtual reality (Virtual Reality, VR) terminal device, an augmented reality (Augmented Reality, AR) terminal device, a small-sized charging household appliance (for example, a soy milk maker or a robotic vacuum cleaner), an uncrewed aerial vehicle, a radar, an aerospace device, and a vehicle-mounted device. The electronic device may alternatively be a network device like a base station. A specific form of the electronic device is not specifically limited in embodiments of this application.

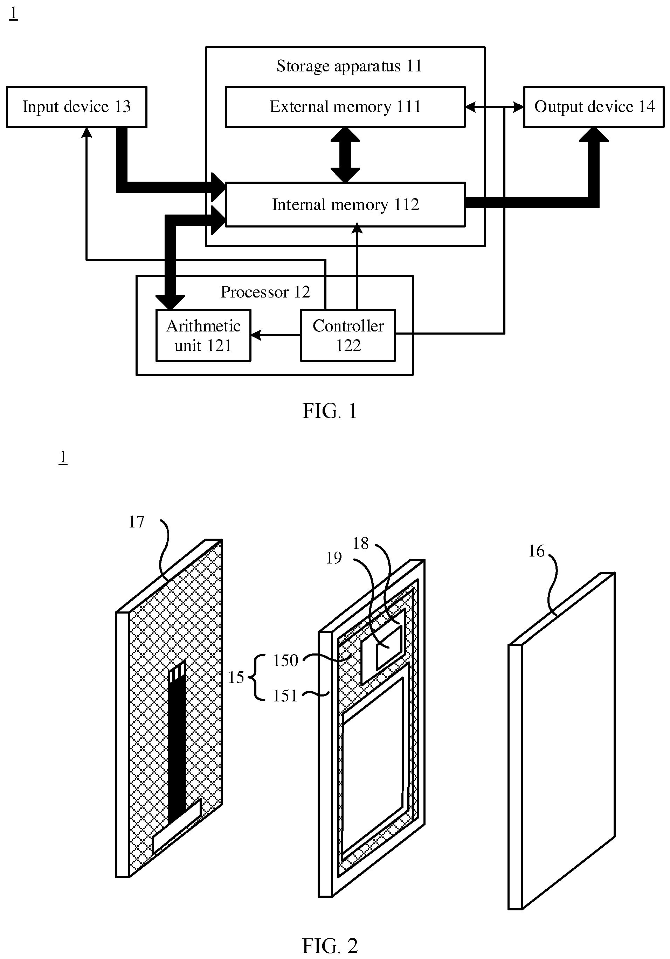

FIG. 1 is a diagram of an architecture of an electronic device according to some embodiments.

Refer to FIG. 1. The electronic device 1 includes components such as a storage apparatus 11, a processor 12, an input device 13, and an output device 14. A person skilled in the art may understand that the architecture of the electronic device 1 shown in FIG. 1 does not constitute a limitation on the electronic device 1. The electronic device 1 may include more or fewer components than those shown in FIG. 1, or may combine some of the components shown in FIG. 1. Alternatively, component arrangement may be different from that shown in FIG. 1.

The storage apparatus 11 is configured to store a software program and a module. The storage apparatus 11 mainly includes a program storage area and a data storage area. The program storage area may store and back up an operating system, an application required by at least one function (such as a sound play function or an image play function), and the like. The data storage area may store data (such as audio data, image data, and a phone book) created based on use of the electronic device 1, and the like. In addition, the storage apparatus 11 includes an external memory 111 and an internal memory 112. Data stored in the external memory 111 and the internal memory 112 may be transmitted to each other. The external memory 111 may include, for example, a hard disk, a USB flash drive, and a floppy disk. For example, the internal memory 112 may include a random access memory (Random Access Memory, RAM), a read-only memory (Read-Only Memory, ROM), or the like.

The processor 12 is a control center of the electronic device 1, is connected to all parts of the entire electronic device 1 through various interfaces and lines, and performs various functions and data processing of the electronic device 1 by running or executing a software program and/or a module stored in the storage apparatus 11 and invoking data stored in the storage apparatus 11. In this way, overall monitoring is performed on the electronic device 1. Optionally, the processor 12 may include one or more processing units. For example, the processor 12 may include an application processor (Application Processor, AP), a modem processor, a graphics processing unit (Graphics Processing Unit, GPU), and the like. Different processing units may be independent components, or may be integrated into one or more processors. For example, the processor 12 may integrate an application processor and a modem processor. The application processor mainly processes an operating system, a user interface, an application, and the like. The modem processor mainly processes wireless communication. It may be understood that the modem processor may be not integrated into the processor 12. The application processor may be, for example, a central processing unit (Central Processing Unit, CPU). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write the data.

The input device 13 is configured to receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory such as a finger or a stylus pen), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to output a signal corresponding to data that is input by the input device 13 and stored in the internal memory 112. For example, the output device 14 outputs a sound signal or a video signal. The controller 122 in the processor 12 may further control the output device 14 to output a signal or not to output a signal.

It should be noted that a thick arrow in FIG. 1 indicates data transmission, and a direction of the thick arrow indicates a data transmission direction. For example, a unidirectional arrow between the input device 13 and the internal memory 112 indicates that data received by the input device 13 is transmitted to the internal memory 112. For another example, a bidirectional arrow between the arithmetic unit 121 and the internal memory 112 indicates that the data stored in the internal memory 112 may be transmitted to the arithmetic unit 121, and data processed by the arithmetic unit 121 may be transmitted to the internal memory 112. A thin arrow in FIG. 1 indicates a component that can be controlled by the controller 122. For example, the controller 122 may control the external memory 111, the internal memory 112, the arithmetic unit 121, the input device 13, the output device 14, and the like.

For ease of further describing the structure of the electronic device 1, the following uses an example in which the electronic device 1 is a mobile phone for description.

FIG. 2 is an exploded view of an electronic device according to some embodiments.

Refer to FIG. 2. The electronic device 1 may further include a middle frame 15, a rear housing 16, and a display 17. The rear housing 16 and the display 17 are respectively located on two opposite sides of the middle frame 15, and the middle frame 15 and the display 17 are disposed in the rear housing 16. The middle frame 15 includes a bearing plate 150 configured to bear the display 17, and a frame 151 that surrounds the bearing plate 150.

Still refer to FIG. 2. The electronic device 1 may further include a circuit board 18. The circuit board 18 is disposed on a side that is of the bearing plate 150 and that is close to the rear housing 16. The electronic device 1 further includes a chip 19 disposed on the circuit board 18, and the chip 19 is electrically connected to the circuit board 18.

The chip 19 may be a ferroelectric memory. For example, the internal memory 112 in the electronic device 1 is a ferroelectric memory, and has high storage density. The ferroelectric memory may be a ferroelectric random access memory, or may be a ferroelectric field effect transistor memory.

The chip 19 may alternatively be a three-dimensional integrated circuit. The three-dimensional integrated circuit includes a homogeneous three-dimensional integrated circuit and a heterogeneous three-dimensional integrated circuit. The homogeneous three-dimensional integrated circuit includes a multi-layer active component integrated in a thickness direction of the homogeneous three-dimensional integrated circuit, and has features of low costs and high size precision. The heterogeneous three-dimensional integrated circuit includes a plurality of chips that are integrated, and the chips have different process architectures, different instruction sets, or different functions. In other words, the heterogeneous three-dimensional integrated circuit integrates different semiconductor materials, semiconductor processes, semiconductor structures, or semiconductor devices.

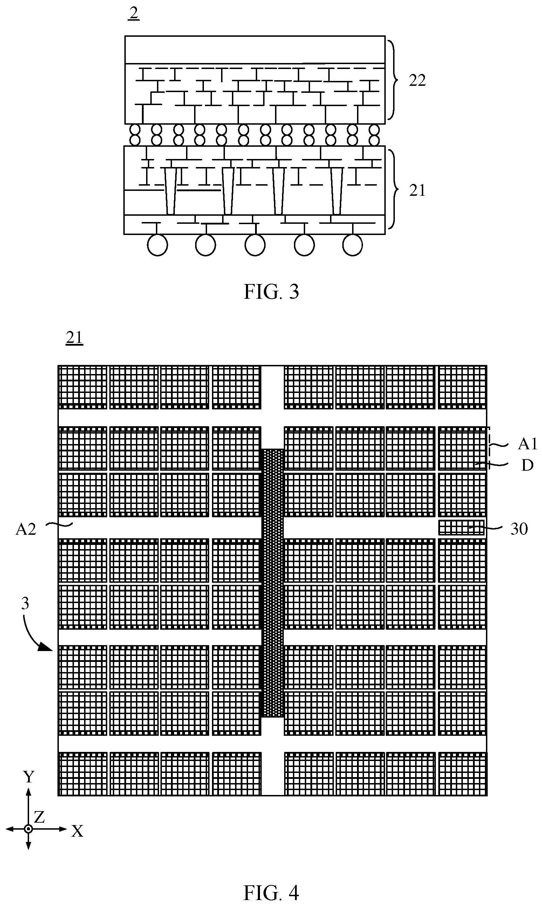

FIG. 3 is a diagram of a structure of a three-dimensional integrated circuit according to some embodiments.

Refer to FIG. 3. The three-dimensional integrated circuit 2 includes two three-dimensional stacked (3D stacked) chips. One chip may be, for example, a ferroelectric memory 21, and the other chip may be, for example, a processor chip 22; and the two chips are electrically connected.

For example, the processor chip 22 may include a plurality of logic chips. In this case, the plurality of logic chips are stacked on the ferroelectric memory 21 and are electrically connected to the ferroelectric memory 21.

For example, the processor chip 22 may also adopt a system on chip (System On Chip, SoC) structure design. In this case, a system on chip is stacked on the ferroelectric memory 21, and is electrically connected to the ferroelectric memory 21.

The foregoing three-dimensional integrated circuit 2 is the heterogeneous three-dimensional integrated circuit, and has large memory access bandwidth (memory access bandwidth). Therefore, the three-dimensional integrated circuit 2 is applicable to an application scenario with a large bandwidth requirement, for example, an application scenario like artificial intelligence or data processing.

In the three-dimensional integrated circuit 2, to ensure power integrity of the chip, a decoupling capacitor needs to be disposed in a power distribution network of the chip, so that the power distribution network can provide a stable power supply. The decoupling capacitor may be disposed in the processor chip 22 of the three-dimensional integrated circuit 2, or may be disposed in the ferroelectric memory 21.

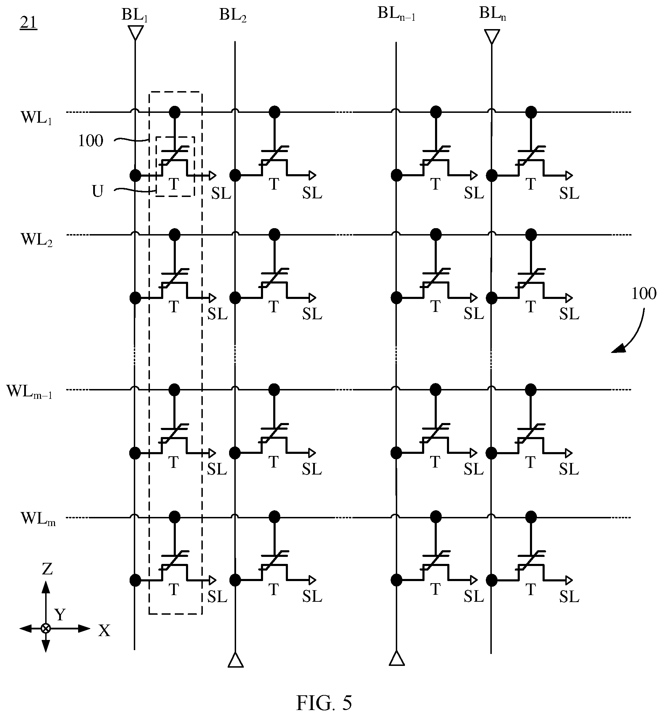

FIG. 4 is a top view of a ferroelectric memory according to some embodiments. FIG. 5 is a diagram of an architecture of a memory array of a ferroelectric memory according to some embodiments.

Refer to FIG. 4 and FIG. 5. An example in which the ferroelectric memory 21 is a ferroelectric field effect transistor memory is used. The ferroelectric memory 21 includes an array region A1 and a routing region A2. The ferroelectric memory 21 may include a memory array disposed in the array region A1. The memory array includes a second stacked layer D. The second stacked layer D includes a plurality of memory cells U arranged in an array. In a direction Z, the plurality of memory cells U form one memory cell string 100. In an X-Y plane, a plurality of memory cell strings 100 may form a memory array, and a source layer SL may be electrically connected to sources of the plurality of memory cell strings 100.

For example, refer to FIG. 5. The memory cell U may include one transistor T. In the direction Z, a plurality of transistors T are connected together to form the memory cell string 100.

For example, as shown in FIG. 5, the transistor T is a ferroelectric field effect transistor. A control electrode of the ferroelectric field effect transistor is electrically connected to word lines (a WL₁, a WL₂, ..., a WL₁, and a WLₘ), a source is electrically connected to the source layer SL, a drain is electrically connected to bit lines (a BL₁, a BL₂, ..., a BLₙ₋₁, and a BLₙ), and a material of a gate dielectric layer of the ferroelectric field effect transistor is a ferroelectric material. The ferroelectric field effect transistor changes a polarity of a ferroelectric layer by using a voltage pulse to store data, and obtains the stored data by reading a current of the transistor. A reading mechanism of the ferroelectric field effect transistor is non-destructive and has high density.

It should be noted that a quantity of transistors T in the memory cell string 100 in FIG. 5 is merely an example. The memory cell string 100 in the ferroelectric memory 21 provided in this embodiment of this application may further include another quantity of transistors T, for example, 8, 16, 32, and 64.

Still refer to FIG. 4 and FIG. 5. The ferroelectric memory 21 further includes a capacitor disposed in the routing region A2, and the capacitor includes a first stacked layer 30. For example, the capacitor may be used as a decoupling capacitor. The following describes a decoupling capacitor in a related technology.

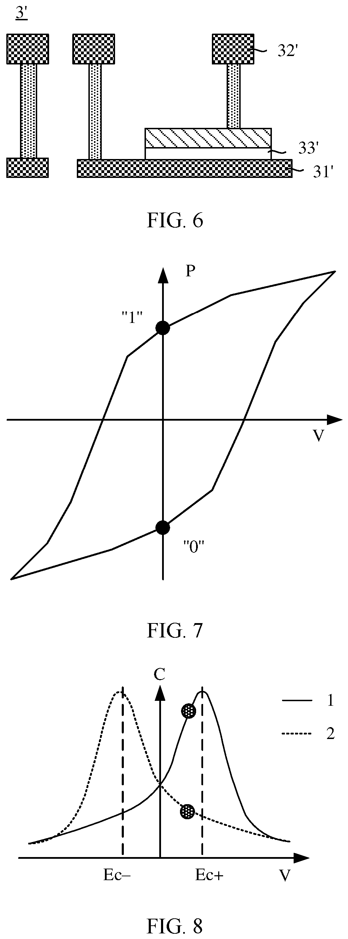

FIG. 6 is a diagram of a structure of a decoupling capacitor in a related technology.

Refer to FIG. 6. The decoupling capacitor 3' includes a first conducting layer 31' and a second conducting layer 32', and a dielectric layer 33' disposed between the first conducting layer 31' and the second conducting layer 32'. A material of the dielectric layer 33' may be a ferroelectric material, and a dielectric constant of the ferroelectric material is large. This helps increase a capacitance value of the decoupling capacitor 3'.

When the dielectric layer 33' is made of the ferroelectric material, the decoupling capacitor 3' is a ferroelectric capacitor. The ferroelectric capacitor has a coercive electric field. When an electric potential difference between two poles of the ferroelectric capacitor increases, and an electric field generated by the two poles is greater than the coercive electric field, polarization reversal occurs in a ferroelectric domain in the ferroelectric material, and the ferroelectric capacitor changes from one polarization state to another polarization state.

FIG. 7 is a diagram of an electric hysteresis loop of a ferroelectric material in a ferroelectric capacitor. A horizontal coordinate "V" indicates an electric potential difference between two poles of the ferroelectric capacitor, and a vertical coordinate "P" indicates polarization strength of the ferroelectric material.

It can be learned that when the electric potential difference between the two poles of the ferroelectric capacitor increases, and an electric field generated by the two poles is greater than a coercive electric field, polarization reversal occurs in a ferroelectric domain in the ferroelectric material, and the polarization strength of the ferroelectric material changes. In other words, a polarization state of the ferroelectric capacitor changes. For example, the ferroelectric capacitor changes from a "0" state to a "1" state.

FIG. 8 is a curve diagram of relationships between capacitance values of a ferroelectric capacitor before and after polarization reversal occurs and an electric potential difference between two poles of the ferroelectric capacitor. A horizontal coordinate "V" indicates the electric potential difference between the two poles of the ferroelectric capacitor, and a vertical coordinate "C" indicates the capacitance value of the ferroelectric capacitor. A curve "1" is a curve of the relationship between the capacitance value of the ferroelectric capacitor before the polarization reversal occurs and the electric potential difference between the two poles of the ferroelectric capacitor, and a curve "2" is a curve of the relationship between the capacitance value of the ferroelectric capacitor after the polarization reversal occurs and the electric potential difference between the two poles of the ferroelectric capacitor.

It can be seen that, when the electric potential difference between the two poles of the ferroelectric capacitor remains unchanged before and after the polarization reversal occurs, the capacitance value of the ferroelectric capacitor before the polarization reversal occurs is greater than the capacitance value of the ferroelectric capacitor after the polarization reversal occurs.

It can be learned from the above that, due to a polarization reversal feature of the ferroelectric material, when the electric potential difference between the two poles of the ferroelectric capacitor is large, the polarization reversal occurs on the ferroelectric material. As a result, the capacitance value of the ferroelectric capacitor changes, and an anti-interference capability of the ferroelectric capacitor is poor.

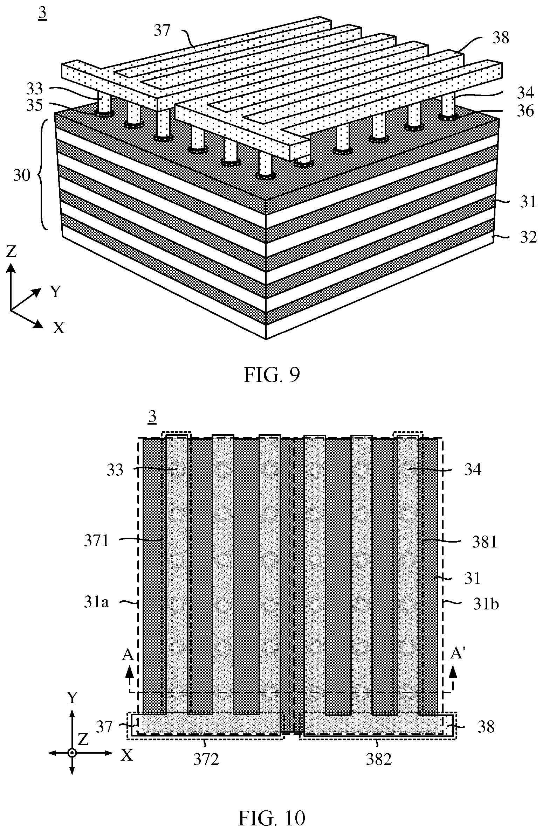

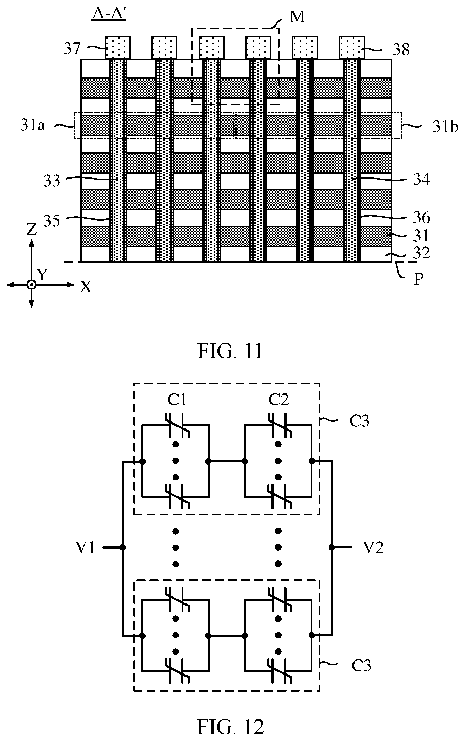

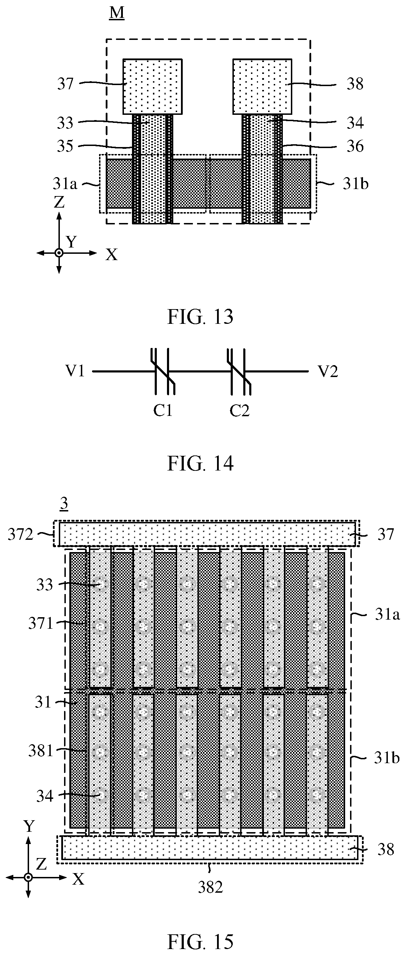

To resolve the foregoing problem, some embodiments of this application provide a capacitor. FIG. 9 is a diagram of a structure of a capacitor according to some embodiments. FIG. 10 is a top view of the capacitor in FIG. 9. FIG. 11 is a cross-sectional view of the capacitor in FIG. 10 along a section line A-A'. FIG. 12 is an equivalent circuit schematic of the capacitor in FIG. 11. FIG. 13 is a partially enlarged view of the capacitor in FIG. 11 at M. FIG. 14 is an equivalent circuit schematic of the capacitor in FIG. 13.

Refer to FIG. 9. The capacitor 3 includes the first stacked layer 30. The first stacked layer 30 includes a plurality of conducting layers 31 and a plurality of first dielectric layers 32 that are alternately stacked. In other words, two adjacent conducting layers 31 are separated by one first dielectric layer 32.

It should be noted that quantities of the conducting layers 31 and the first dielectric layers 32 in FIG. 9 are merely used as examples. This is not limited in this embodiment of this application.

The second stacked layer D disposed in the array region A1 mentioned above includes dielectric layers and gate layers that are alternately disposed, the plurality of first dielectric layers 32 of the first stacked layer 30 one-to-one correspond to a plurality of dielectric layers of the second stacked layer D, and a first dielectric layer and a dielectric layer of the second stacked layer D that correspond to each other have a same material and are disposed at a same layer.

The plurality of conducting layers 31 of the first stacked layer 30 one-to-one correspond to a plurality of gate layers of the second stacked layer D, and a conducting layer 31 and a gate layer that correspond to each other have a same material and are disposed at a same layer.

In addition, the conducting layer 31 of the first stacked layer 30 is insulated from the gate layer of the second stacked layer D. For example, the first stacked layer 30 is disposed in the routing region A2, the second stacked layer D is disposed in the array region A1, and the first stacked layer 30 and the second stacked layer D are disposed in different regions and are discontinuous. In other words, the conducting layer 31 of the first stacked layer 30 is disconnected from the gate layer of the second stacked layer D.

Refer to FIG. 10 and FIG. 11. The plurality of conducting layers 31 include first conductive portions 31a and second conductive portions 31b that are connected.

For example, as shown in FIG. 9, one conducting layer 31 includes one first conductive portion 31a and one second conductive portion 31b. The first conductive portion 31a and the second conductive portion 31b of the same conducting layer 31 are located at the same conducting layer and are connected to each other.

Refer to FIG. 11 and FIG. 13. The capacitor 3 further includes a first conductive pillar 33 and a second conductive pillar 34. The first conductive pillar 33 penetrates the first conductive portion 31a, and the second conductive pillar 34 penetrates the second conductive portion 31b.

For example, as shown in FIG. 11, each first conductive pillar 33 penetrates the first conductive portions 31a of the plurality of conducting layers 31, and each second conductive pillar 34 penetrates the second conductive portions 31b of the plurality of conducting layers 31.

Still refer to FIG. 11 and FIG. 13. The capacitor 3 further includes a first ferroelectric layer 35 and a second ferroelectric layer 36. Both the first ferroelectric layer 35 and the second ferroelectric layer 36 are of cylindrical structures.

The first ferroelectric layer 35 penetrates the first conductive portion 31a, and is disposed around the first conductive pillar 33. The first ferroelectric layer 35 is disposed between the first conductive pillar 33 and the first conductive portion 31a, to insulate the first conductive pillar 33 from the first conductive portion 31a. The second ferroelectric layer 36 penetrates the second conductive portion 31b, and is disposed around the second conductive pillar 34. The second ferroelectric layer 36 is located between the second conductive pillar 34 and the second conductive portion 31b, to insulate the second conductive pillar 34 from the second conductive portion 31b.

For example, as shown in FIG. 11, each first ferroelectric layer 35 penetrates the first conductive portions 31a of the plurality of conducting layers 31, and is disposed around the first conductive pillar 33, to separate the first conductive pillar 33 from the first conductive portions 31a of the plurality of conducting layers 31. Each second ferroelectric layer 36 penetrates the second conductive portions 31b of the plurality of conducting layers 31, and is disposed around the second conductive pillar 34, to separate the second conductive pillar 34 from the second conductive portions 31b of the plurality of conducting layers 31.

It may be understood that, as shown in FIG. 11 to FIG. 14, the first conductive pillar 33, the first ferroelectric layer 35, and the first conductive portion 31a are configured to form a first capacitor C1, and the first conductive pillar 33 and the first conductive portion 31a are two poles of the first capacitor C1. The second conductive pillar 34, the second ferroelectric layer 36, and the second conductive portion 31b are configured to form a second capacitor C2, and the second conductive pillar 34 and the second conductive portion 31b are two poles of the second capacitor C2. Both the first capacitor C1 and the second capacitor C2 are ferroelectric capacitors.

Because the first conductive portion 31a is connected to the second conductive portion 31b, that is, one electrode of the first capacitor C1 is electrically connected to one electrode of the second capacitor C2, the first capacitor C1 and the second capacitor C2 are disposed in series.

In the capacitor 3 provided in the foregoing embodiment of this application, the first conductive pillar 33 is used to penetrate the first conductive portion 31a of the conducting layer 31, and the first ferroelectric layer 35 is disposed around the first conductive pillar 33, to separate the first conductive pillar 33 from the first conductive portion 31a. The first conductive pillar 33, the first ferroelectric layer 35, and the first conductive portion 31a form the first capacitor C1, and the first conductive pillar 33 and the first conductive portion 31a are used as the two poles of the first capacitor C1.

In addition, the second conductive pillar 34 is used to penetrate the second conductive portion 31b of the conducting layer 31, and the second ferroelectric layer 36 is disposed around the second conductive pillar 34, to separate the second conductive pillar 34 from the second conductive portion 31b. The second conductive pillar 34, the second ferroelectric layer 36, and the second conductive portion 31b form the second capacitor C2, and the second conductive pillar 34 and the second conductive portion 31b are used as the two poles of the second capacitor C2.

The one electrode of the first capacitor C1 is electrically connected to the one electrode of the second capacitor C2 by connecting the first conductive portion 31a to the second conductive portion 31b, so that the first capacitor C1 and the second capacitor C2 are disposed in series. Refer to FIG. 13. The first capacitor C1 and the second capacitor C2 form a series circuit, and an electric potential difference between two ends of the series circuit is V1-V2. According to a series voltage division principle, an electric potential difference between two ends of the first capacitor C1 needs to be less than V1-V2, and an electric potential difference between two ends of the second capacitor C2 needs to be less than V1-V2. In other words, an electric potential difference between two ends of each capacitor can be reduced by connecting capacitors in series, to reduce a probability of polarization reversal at a ferroelectric layer of the capacitor, ensure a stable capacitance value of the capacitor, and improve an anti-interference capability of the capacitor.

It can be learned from the foregoing that the capacitors are connected in series by connecting the first conductive portion 31a and the second conductive portion 31b in the conducting layer 31. The following embodiments of this application provide a plurality of arrangement manners of the first conductive portion 31a and the second conductive portion 31b, to describe a manner of connecting the capacitors in series.

In some embodiments, one conducting layer 31 includes at least one first conductive portion 31a and at least one second conductive portion 31b, and the first conductive portion 31a and the second conductive portion 31b that are connected are located at a same conducting layer, so that the first conductive portion 31a is connected to the second conductive portion 31b.

For example, refer to FIG. 10 and FIG. 11. One conducting layer 31 includes one first conductive portion 31a and one second conductive portion 31b. The first conductive portion 31a and the second conductive portion 31b are connected to each other and are located at a same conducting layer.

For example, refer to FIG. 11. The first conductive portion 31a and the second conductive portion 31b that are located at the same conducting layer are integrally disposed.

The first conductive portion 31a and the second conductive portion 31b are arranged in a first direction that is parallel to a bottom surface P of the first stacked layer 30.

It should be noted that the first direction may be an X direction or a Y direction. For example, the first direction in FIG. 10 is the X direction.

In some embodiments, refer to FIG. 11 and FIG. 12. A plurality of first conductive pillars 33 penetrate the first conductive portion 31a of one conducting layer 31, which is equivalent to a plurality of first capacitors C1 being disposed in parallel. A plurality of second conductive pillars 34 penetrate the second conductive portion 31b of one conducting layer 31, which is equivalent to a plurality of second capacitors C2 being disposed in parallel. The first conductive portion 31a and the second conductive portion 31b that are at the same conducting layer 31 are connected, so that the plurality of first capacitors C1 connected in parallel are connected in series to the plurality of second capacitors C2 connected in parallel to form a third capacitor C3.

In the foregoing embodiment of this application, a total capacitance value of the plurality of first capacitors C1 connected in parallel is greater than a capacitance value of one first capacitor C1, and a total capacitance value of the plurality of second capacitors C2 connected in parallel is greater than a capacitance value of one second capacitor C2. A capacitance value of the third capacitor C3 can be increased, thereby increasing a total capacitance value of the capacitor 3.

In addition, the plurality of first capacitors C1 connected in parallel are connected in series to the plurality of second capacitors C2 connected in parallel to form the third capacitor C3, thereby reducing an electric potential difference between two ends of the plurality of capacitors (the first capacitors C1 or the second capacitors C2) connected in parallel, and reducing the electric potential difference between the two ends of each capacitor, to reduce the probability of the polarization reversal at the ferroelectric layer of the capacitor, ensure the stable capacitance value of the capacitor, and improve the anti-interference capability of the capacitor.

In some embodiments, refer to FIG. 11 and FIG. 12. The plurality of first conductive pillars 33 penetrate the first conductive portions 31a of the plurality of conducting layers 31, and the plurality of second conductive pillars 34 penetrate the second conductive portions 31b of the plurality of conducting layers 31, which is equivalent to a plurality of third capacitors C3 being disposed in parallel. A total capacitance value of the capacitor 3 can also be increased.

In some embodiments, refer to FIG. 10 and FIG. 11. The capacitor 3 further includes a first interconnection electrode 37 and a second interconnection electrode 38, and both the first interconnection electrode 37 and the second interconnection electrode 38 are of comb structures. The first interconnection electrode 37 and the second interconnection electrode 38 are arranged in a first direction.

With reference to FIG. 10, the first interconnection electrode 37 includes a plurality of first interconnection lines 371 and a first connection portion 372. Same ends of the plurality of first interconnection lines 371 are connected to the first connection portion 372 to form the comb structure. The plurality of first interconnection lines 371 are "comb teeth" of the comb structure, and the first connection portion 372 is a "comb back" of the comb structure.

Similarly, the second interconnection electrode 38 includes a plurality of second interconnection lines 381 and a second connection portion 382. Same ends of the plurality of second interconnection lines 381 are connected to the second connection portion 382 to form the comb structure. The plurality of second interconnection lines 381 are "comb teeth" of the comb structure, and the second connection portion 382 is a "comb back" of the comb structure.

Still refer to FIG. 10 and FIG. 11. Both the first interconnection line 371 and the second interconnection line 381 extend in a second direction. The second direction is parallel to a bottom surface P of the first stacked layer 30, and intersects with the first direction, for example, the second direction is perpendicular to the first direction. It may be understood that an extension direction of the first interconnection line 371 and the second interconnection line 381 is different from an arrangement direction of the first interconnection electrode 37 and the second interconnection electrode 38.

For example, the first direction is either an X direction or a Y direction, and the second direction is the other. For example, in FIG. 10, the first direction is the X direction, and the second direction is the Y direction.

The plurality of first interconnection lines 371 are electrically connected to end portions of the plurality of first conductive pillars 33, and the plurality of first interconnection lines 371 are connected to one side of the first stacked layer 30 in the second direction, that is, the first connection portion 372 of the first interconnection electrode 37 is located on the side of the first stacked layer 30 in the second direction. An electric signal is transmitted to the plurality of first conductive pillars 33 via the plurality of first interconnection lines 371 of the first interconnection electrode 37.

The plurality of second interconnection lines 381 are electrically connected to end portions of the plurality of second conductive pillars 34, and the plurality of second interconnection lines 381 are connected to a side of the first stacked layer 30 in the second direction, that is, the second connection portion 382 of the second interconnection electrode 38 is located on the side of the first stacked layer 30 in the second direction. An electric signal is transmitted to the plurality of second conductive pillars 34 via the plurality of second interconnection lines 381 of the second interconnection electrode 38.

For example, the first connection portion 372 and the second connection portion 382 may be located on a same side of the first stacked layer 30 in the second direction, or may be separately located on two opposite sides of the first stacked layer 30 in the second direction.

FIG. 15 is a top view of another capacitor according to some embodiments.

In some embodiments, refer to FIG. 15. Both the first interconnection electrode 37 and the second interconnection electrode 38 are also of comb structures, and the first interconnection electrode 37 and the second interconnection electrode 38 are arranged in a first direction.

For example, in FIG. 15, the first direction is a Y direction, and the second direction is an X direction.

Both the first interconnection line 371 of the first interconnection electrode 37 and the second interconnection line 381 of the second interconnection electrode 38 extend in the first direction. In other words, an extension direction of the first interconnection line 371 and the second interconnection line 381 is the same as an arrangement direction of the first interconnection electrode 37 and the second interconnection electrode 38.

The plurality of first interconnection lines 371 are electrically connected to end portions of the plurality of first conductive pillars 33, and the plurality of first interconnection lines 371 are connected to one side of the first stacked layer 30 in the first direction, that is, the first connection portion 372 of the first interconnection electrode 37 is located on the side of the first stacked layer 30 in the first direction. An electric signal is transmitted to the plurality of first conductive pillars 33 via the plurality of first interconnection lines 371 of the first interconnection electrode 37.

The plurality of second interconnection lines 381 are electrically connected to end portions of the plurality of second conductive pillars 34, and the plurality of second interconnection lines 381 are connected to the other side of the first stacked layer 30 in the first direction, that is, the second connection portion 382 of the second interconnection electrode 38 is located on the other side of the first stacked layer 30 in the first direction. An electric signal is transmitted to the plurality of second conductive pillars 34 via the plurality of second interconnection lines 381 of the second interconnection electrode 38.

For example, the first connection portion 372 and the second connection portion 382 are separately located on two opposite sides of the first stacked layer 30 in the first direction.

In some embodiments, refer to FIG. 15. There are a plurality of rows of the plurality of first conductive pillars 33. For example, each row of first conductive pillars 33 may extend in a same direction as the first interconnection line 371. One first interconnection line 371 is electrically connected to one row of first conductive pillars 33, to transmit the electrical signal to the row of first conductive pillars 33 via the first interconnection line 371.

Alternatively, there are a plurality of rows of the plurality of second conductive pillars 34. For example, each row of second conductive pillars 34 may extend in a same direction as the second interconnection line 381. One second interconnection line 381 is electrically connected to one row of second conductive pillars 34, to transmit the electrical signal to the row of second conductive pillars 34 via the second interconnection line 381.

Alternatively, there are a plurality of rows of the plurality of first conductive pillars 33, and one first interconnection line 371 is electrically connected to one row of first conductive pillars 33. There are a plurality of rows of the plurality of second conductive pillars 34, and one second interconnection line 381 is electrically connected to one row of second conductive pillars 34.

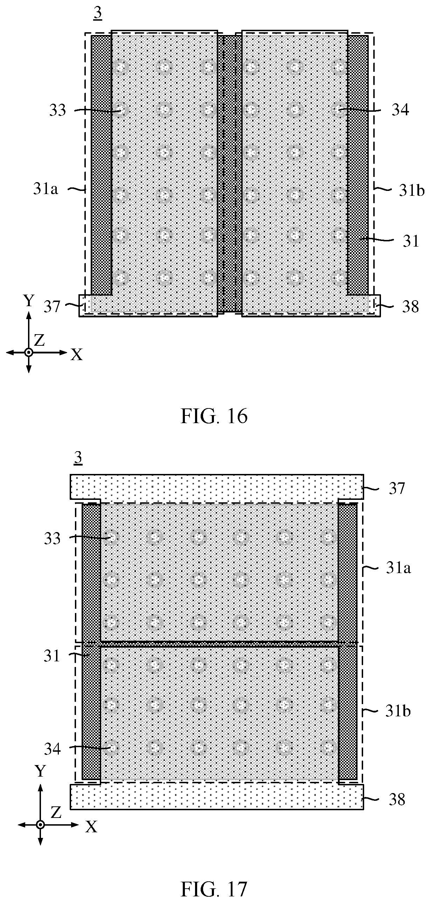

FIG. 16 and FIG. 17 are top views of another capacitor according to some embodiments.

In some embodiments, refer to FIG. 16 and FIG. 17. Both the first interconnection electrode 37 and the second interconnection electrode 38 are of planar structures, and the first interconnection electrode 37 and the second interconnection electrode 38 are arranged in a first direction.

For example, in FIG. 16, the first direction is an X direction, and a second direction is a Y direction. In FIG. 17, the first direction is the Y direction, and the second direction is the X direction.

The planar first interconnection electrode 37 is electrically connected to end portions of the plurality of first conductive pillars 33, to transmit an electrical signal to the plurality of first conductive pillars 33 via the first interconnection electrode 37.

The planar second interconnection electrode 38 is electrically connected to end portions of the plurality of second conductive pillars 34, to transmit an electrical signal to the plurality of second conductive pillars 34 via the second interconnection electrode 38.

In some embodiments, refer to FIG. 16 and FIG. 17. The plurality of first conductive pillars 33 are arranged in an array, or the plurality of second conductive pillars 34 are arranged in an array, or both the plurality of first conductive pillars 33 and the plurality of second conductive pillars 34 are arranged in arrays. This can improve uniformity of arrangement of the plurality of first conductive pillars 33 and the plurality of second conductive pillars 34, and help reduce signal interference between a plurality of capacitors.

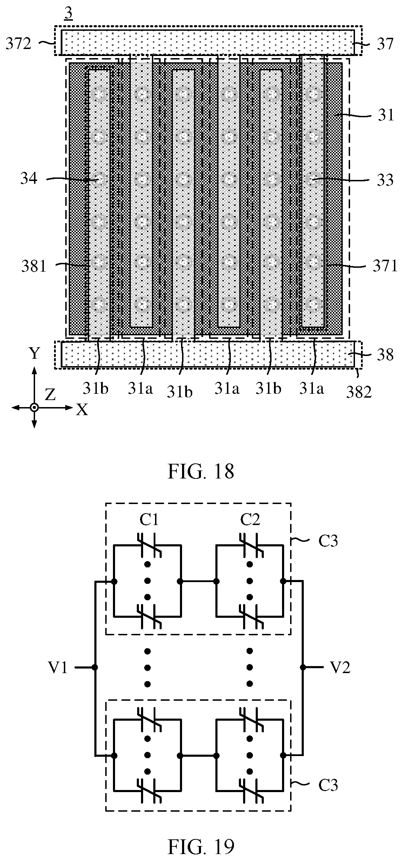

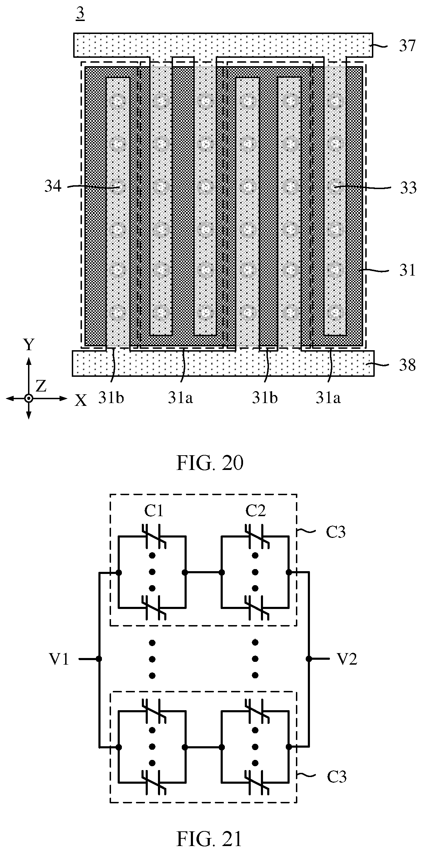

FIG. 18 is a top view of another capacitor according to some embodiments. FIG. 19 is an equivalent circuit schematic of the capacitor in FIG. 18. FIG. 20 is a top view of still another capacitor according to some embodiments. FIG. 21 is an equivalent circuit schematic of the capacitor in FIG. 20.

In some embodiments, refer to FIG. 18 and FIG. 20. One conducting layer 31 may include a plurality of first conductive portions 31a and a plurality of second conductive portions 31b. The plurality of first conductive portions 31a are connected to the plurality of second conductive portions 31b and are all located at a same conducting layer. For example, the plurality of first conductive portions 31a and the plurality of second conductive portions 31b that are located at the same conducting layer are integrally disposed.

The first conductive portions 31a and the second conductive portions 31b are alternately arranged in a first direction. For example, in both FIG. 18 and FIG. 20, first directions are X directions.

In some embodiments, refer to FIG. 18 and FIG. 19, or FIG. 20 and FIG. 21. The plurality of first conductive pillars 33 penetrate the plurality of first conductive portions 31a, which is equivalent to a plurality of first capacitors C1 being disposed in parallel. The plurality of second conductive pillars 34 penetrate the plurality of second conductive portions 31b, which is equivalent to a plurality of second capacitors C2 being disposed in parallel. The plurality of first conductive portions 31a and the plurality of second conductive portions 31b that are at the same conducting layer 31 are connected, so that the plurality of first capacitors C1 connected in parallel are connected in series to the plurality of second capacitors C2 connected in parallel to form a third capacitor C3.

In the foregoing embodiment, an electric potential difference between two ends of each capacitor can be reduced by connecting the capacitors in series, to reduce a probability of polarization reversal at a ferroelectric layer of the capacitor, ensure a stable capacitance value of the capacitor, and improve an anti-interference capability of the capacitor.

In some embodiments, refer to FIG. 18 and FIG. 19, or FIG. 20 and FIG. 21. The plurality of first conductive pillars 33 penetrate the first conductive portions 31a of the plurality of conducting layers 31, and the plurality of second conductive pillars 34 penetrate the second conductive portions 31b of the plurality of conducting layers 31, which is equivalent to a plurality of third capacitors C3 being disposed in parallel. A total capacitance value of the capacitor 3 can also be increased.

In some embodiments, refer to FIG. 18 and FIG. 20. The capacitor 3 further includes a first interconnection electrode 37 and a second interconnection electrode 38, and both the first interconnection electrode 37 and the second interconnection electrode 38 are of comb structures.

With reference to FIG. 18, the first interconnection electrode 37 includes a plurality of first interconnection lines 371 and a first connection portion 372. Same ends of the plurality of first interconnection lines 371 are connected to the first connection portion 372 to form the comb structure. The plurality of first interconnection lines 371 are "comb teeth" of the comb structure, and the first connection portion 372 is a "comb back" of the comb structure.

Similarly, the second interconnection electrode 38 includes a plurality of second interconnection lines 381 and a second connection portion 382. Same ends of the plurality of second interconnection lines 381 are connected to the second connection portion 382 to form the comb structure. The plurality of second interconnection lines 381 are "comb teeth" of the comb structure, and the second connection portion 382 is a "comb back" of the comb structure.

Still refer to FIG. 18 and FIG. 20. The plurality of first interconnection lines 371 and the plurality of second interconnection lines 381 are arranged in the first direction, and both the first interconnection lines 371 and the second interconnection lines 381 extend in a second direction.

For example, in FIG. 18, the first direction is the X direction, and the second direction is the Y direction. The plurality of first interconnection lines 371 and the plurality of second interconnection lines 381 are alternately arranged in the first direction.

For example, in FIG. 20, the first direction is the X direction, and the second direction is the Y direction. There is no second interconnection line 381 or there are a plurality of second interconnection lines 381 disposed between two adjacent first interconnection lines 371. There is no first interconnection line 371 or there are a plurality of first interconnection lines 371 disposed between two adjacent second interconnection lines 381.

The plurality of first interconnection lines 371 are electrically connected to end portions of the plurality of first conductive pillars 33, and the plurality of first interconnection lines 371 are connected to one side of the first stacked layer 30 in the second direction, that is, the first connection portion 372 of the first interconnection electrode 37 is located on the side of the first stacked layer 30 in the second direction. An electric signal is transmitted to the plurality of first conductive pillars 33 via the plurality of first interconnection lines 371 of the first interconnection electrode 37.

The plurality of second interconnection lines 381 are electrically connected to end portions of the plurality of second conductive pillars 34, and the plurality of second interconnection lines 381 are connected to the other side of the first stacked layer 30 in the second direction, that is, the second connection portion 382 of the second interconnection electrode 38 is located on the other side of the first stacked layer 30 in the second direction. An electric signal is transmitted to the plurality of second conductive pillars 34 via the plurality of second interconnection lines 381 of the second interconnection electrode 38.

In some embodiments, refer to FIG. 18 and FIG. 20. There are a plurality of rows of the plurality of first conductive pillars 33. For example, each row of first conductive pillars 33 may extend in a same direction as the first interconnection line 371. One first interconnection line 371 is electrically connected to one row of first conductive pillars 33, to transmit the electrical signal to the row of first conductive pillars 33 via the first interconnection line 371.

Alternatively, there are a plurality of rows of the plurality of second conductive pillars 34. For example, each row of second conductive pillars 34 may extend in a same direction as the second interconnection line 381. One second interconnection line 381 is electrically connected to one row of second conductive pillars 34, to transmit the electrical signal to the row of second conductive pillars 34 via the second interconnection line 381.

Alternatively, there are a plurality of rows of the plurality of first conductive pillars 33, and one first interconnection line 371 is electrically connected to one row of first conductive pillars 33. There are a plurality of rows of the plurality of second conductive pillars 34, and one second interconnection line 381 is electrically connected to one row of second conductive pillars 34.

In some embodiments, the conducting layer 31 may be further divided into a plurality of blocks, to increase a quantity of capacitors connected in series, further reduce the electric potential difference between the two ends of each capacitor, reduce the probability of the polarization reversal at the ferroelectric layer of the capacitor, ensure the stable capacitance value of the capacitor, and improve the anti-interference capability of the capacitor.

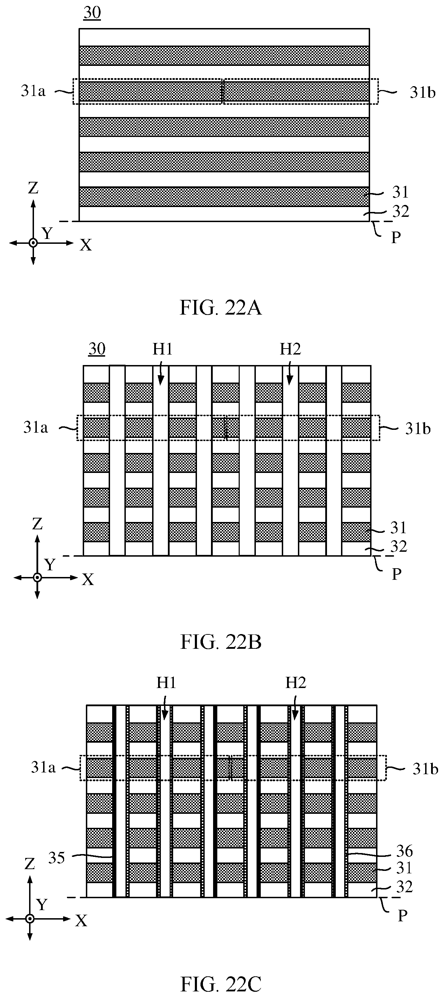

Some embodiments of this application further provide a preparation method for a capacitor. FIG. 22A to FIG. 22E are diagrams of steps for preparing a capacitor according to some embodiments. The preparation method includes the following steps.

Refer to FIG. 22A. The first stacked layer 30 is formed. The first stacked layer 30 includes the plurality of conducting layers 31 and the plurality of first dielectric layers 32 that are alternately stacked, and one conducting layer 31 includes the first conductive portion 31a and the second conductive portion 31b that are connected.

For example, the second stacked layer D is synchronously formed in the array region A1 in a process of forming the first stacked layer 30 in the routing region A2.

Refer to FIG. 22B. The first stacked layer 30 is etched to form a first contact hole H1 that penetrates the first conductive portion 31a and a second contact hole H2 that penetrates the second conductive portion 31b.

For example, the first contact hole H1 penetrates the first conductive portions 31a of the plurality of conducting layers 31, and the second contact hole H2 penetrates the second conductive portions 31b of the plurality of conducting layers 31.

Refer to FIG. 22C. The first ferroelectric layer 35 is formed on a sidewall of the first contact hole H1, and the second ferroelectric layer 36 is formed on a sidewall of the second contact hole H2.

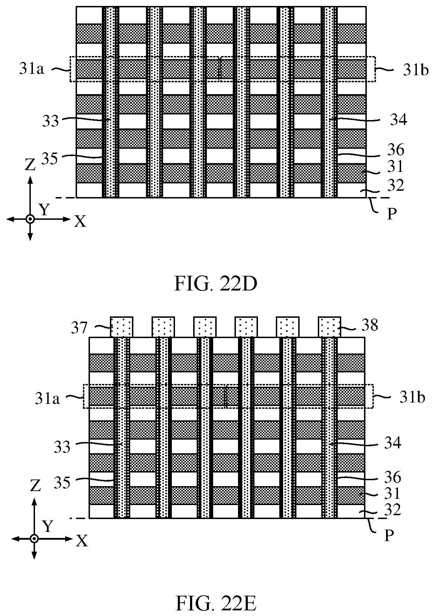

Refer to FIG. 22D. The first conductive pillar 33 is formed on an inner side of the first ferroelectric layer 35, and the second conductive pillar 34 is formed on an inner side of the second ferroelectric layer 36.

According to the preparation method provided in the foregoing embodiment of this application, the first stacked layer 30 is first formed. The first stacked layer 30 includes the plurality of conducting layers 31 and the plurality of first dielectric layers 32 that are alternately stacked, and one conducting layer 31 includes the first conductive portion 31a and the second conductive portion 31b that are connected. Then, the first contact hole H1 that penetrates the first conductive portion 31a and the second contact hole H2 that penetrates the second conductive portion 31b are formed. The first ferroelectric layer 35 and the first conductive pillar 33 are formed on the sidewall of the first contact hole H1, and the second ferroelectric layer 36 and the second conductive pillar 34 are formed on the sidewall of the second contact hole H2.

The first conductive pillar 33, the first ferroelectric layer 35, and the first conductive portion 31a form the first capacitor C1, and the first conductive pillar 33 and the first conductive portion 31a are used as the two poles of the first capacitor C1. The second conductive pillar 34, the second ferroelectric layer 36, and the second conductive portion 31b form the second capacitor C2, and the second conductive pillar 34 and the second conductive portion 31b are used as the two poles of the second capacitor C2. One electrode of the first capacitor C1 is electrically connected to one electrode of the second capacitor C2 by connecting the first conductive portion 31a to the second conductive portion 31b, so that the first capacitor C1 and the second capacitor C2 are disposed in series. An electric potential difference between two ends of each capacitor can be reduced, to reduce a probability of polarization reversal at the ferroelectric layer of the capacitor, ensure a stable capacitance value of the capacitor, and improve an anti-interference capability of the capacitor.

In some embodiments, after the first conductive pillar 33 and the second conductive pillar 34 are formed, the foregoing preparation method further includes the following steps.

Refer to FIG. 22E. The first interconnection electrode 37 and the second interconnection electrode 38 are formed. For example, both the first interconnection electrode 37 and the second interconnection electrode 38 are formed on the top of the first stacked layer 30. The first interconnection electrode 37 is electrically connected to end portions of the plurality of first conductive pillars 33, to transmit an electrical signal to the plurality of first conductive pillars 33. The second interconnection electrode 38 is electrically connected to end portions of the plurality of second conductive pillars 34, to transmit an electrical signal to the plurality of second conductive pillars 34.

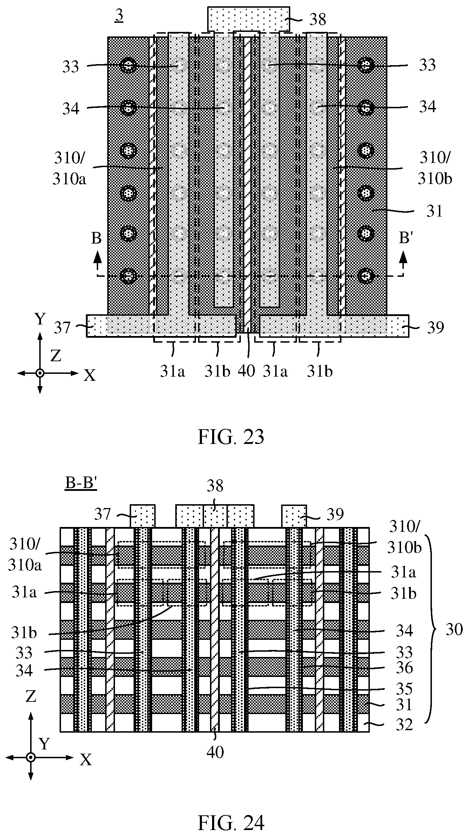

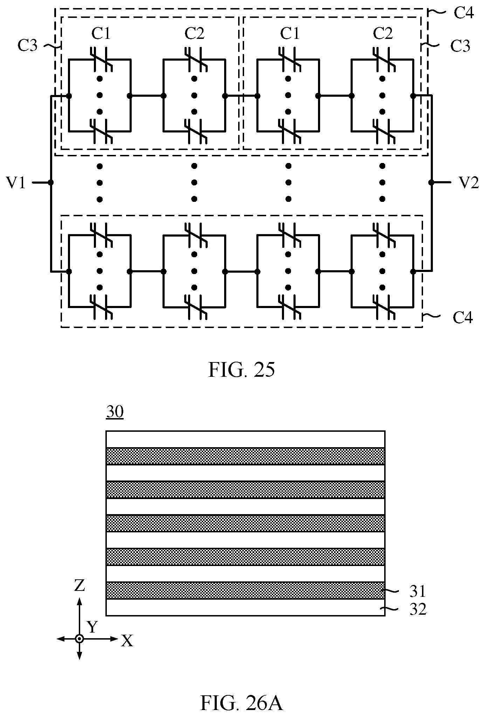

FIG. 23 is a top view of still another capacitor according to some embodiments. FIG. 24 is a cross-sectional view of the capacitor in FIG. 23 along a section line B-B'. FIG. 25 is an equivalent circuit schematic of the capacitor in FIG. 24.

Refer to FIG. 23 and FIG. 24. One conducting layer 31 includes a plurality of spaced-apart conducting blocks 310. This is equivalent to that one conducting layer 31 is divided into a plurality of conducting blocks 310, and the plurality of conducting blocks 310 are disconnected. In addition, one conducting block 310 includes one first conductive portion 31a and one second conductive portion 31b that are connected.

For example, the capacitor 3 further includes a second dielectric layer 40 that penetrates the first stacked layer 30 and separates two adjacent conducting blocks 310. It may be understood that second dielectric layers 40 divide the conducting layer 31 into the plurality of conducting blocks 310.

Refer to FIG. 23 and FIG. 25. The plurality of first conductive pillars 33 penetrate the first conductive portion 31a of one conducting block 310, which is equivalent to the plurality of first capacitors C1 being disposed in parallel. The plurality of second conductive pillars 34 penetrate the second conductive portion 31b of one conducting block 310, which is equivalent to the plurality of second capacitors C2 being disposed in parallel. The first conductive portion 31a and the second conductive portion 31b that are of a same conducting block 310 are connected, so that the plurality of first capacitors C1 connected in parallel are connected in series to the plurality of second capacitors C2 connected in parallel to form the third capacitor C3.

In addition, in the two adjacent conducting blocks 310, the plurality of second conductive pillars 34 that penetrate one conducting block 310 are electrically connected to the plurality of first conductive pillars 33 that penetrate the other conducting block 310, so that third capacitors C3 of the adjacent conducting blocks 310 are connected in series to form a fourth capacitor C4.

In the foregoing embodiment of this application, a total capacitance value of the plurality of first capacitors C1 connected in parallel is greater than a capacitance value of one first capacitor C1, and a total capacitance value of the plurality of second capacitors C2 connected in parallel is greater than a capacitance value of one second capacitor C2. A capacitance value of the third capacitor C3 can be increased, and a capacitance value of the fourth capacitor C4 can be increased, thereby increasing a total capacitance value of the capacitor 3.

In addition, the plurality of first capacitors C1 connected in parallel are connected in series to the plurality of second capacitors C2 connected in parallel to form the third capacitor C3, and the third capacitors C3 of the adjacent conducting blocks 310 are connected in series to form the fourth capacitor C4, to increase a quantity of capacitors connected in series, thereby further reducing the electric potential difference between the two ends of each capacitor, and reducing the probability of the polarization reversal at the ferroelectric layer of the capacitor, ensure the stable capacitance value of the capacitor, and improve the anti-interference capability of the capacitor.

In some embodiments, one conducting layer 31 includes a 1^{st} conducting block to an n^{th} conducting block that are sequentially disposed, n≥2, and n is a positive integer.

For example, refer to FIG. 23 and FIG. 24. One conducting layer 31 includes the 1^{st} conducting block 310a and a 2^{nd} conducting block 310b that are sequentially disposed, that is, n=2.

Still refer to FIG. 23 and FIG. 24. The capacitor 3 further includes one first interconnection electrode 37, at least one second interconnection electrode 38, and one third interconnection electrode 39. The first interconnection electrode 37 is electrically connected to a first conductive pillar 33 that penetrates the 1^{st} conducting block. The second interconnection electrode 38 is electrically connected to a second conductive pillar 34 that penetrates an i^{th} conducting block and a first conductive pillar 33 that penetrates an (i+1)^{th} conducting block, i=1 to n-1, and i is a positive integer. The third interconnection electrode 39 is electrically connected to a second conductive pillar 34 that penetrates the n^{th} conducting block.

For example, refer to FIG. 23 and FIG. 24. One conducting layer 31 includes the 1^{st} conducting block 310a and the 2^{nd} conducting block 310b that are sequentially disposed, that is, n=2. In this case, the capacitor 3 includes one second interconnection electrode 38.

The first interconnection electrode 37 is electrically connected to a first conductive pillar 33 that penetrates the 1^{st} conducting block 310a, the second interconnection electrode 38 is electrically connected to a second conductive pillar 34 that penetrates the 1^{st} conducting block 310a and a first conductive pillar 33 that penetrates the 2^{nd} conducting block 310b, and the third interconnection electrode 39 is electrically connected to a second conductive pillar 34 that penetrates the 2^{nd} conducting block 310b.

It may be understood that, with reference to FIG. 24 and FIG. 25, the first interconnection electrode 37 and the third interconnection electrode 39 receive an external electrical signal, and transmit the electrical signal to the fourth capacitor C4. The second interconnection electrode 38 is used as a connection electrode, and does not receive the external electrical signal.

Some embodiments of this application further provide a preparation method for a capacitor. FIG. 26A to FIG. 26G are diagrams of steps for preparing another capacitor according to some embodiments. The preparation method includes the following steps.

Refer to FIG. 26A. The first stacked layer 30 is formed. The first stacked layer 30 includes the plurality of conducting layers 31 and the plurality of first dielectric layers 32 that are alternately stacked.

For example, the second stacked layer D is synchronously formed in the array region A1 in a process of forming the first stacked layer 30 in the routing region A2.

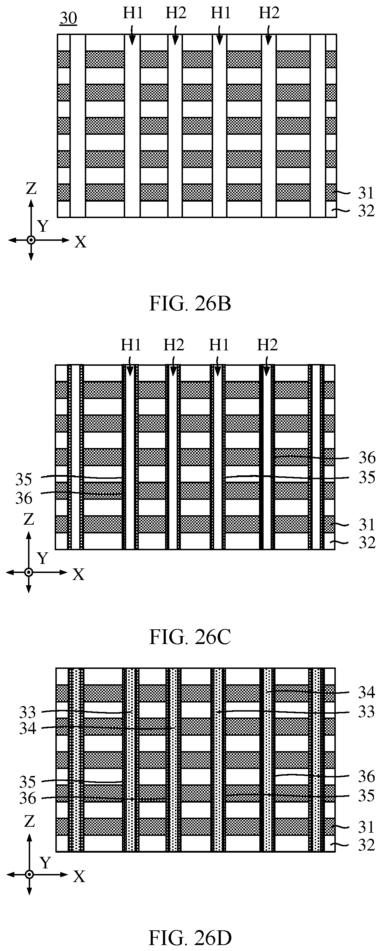

Refer to FIG. 26B. The first stacked layer 30 is etched to form a first contact hole H1 that penetrates the first stacked layer 30 and a second contact hole H2 that penetrates the first stacked layer 30.

For example, the first contact hole H1 penetrates the plurality of conducting layers 31 of the first stacked layer 30, and the second contact hole H2 penetrates the plurality of conducting layers 31 of the first stacked layer 30.

Refer to FIG. 26C. The first ferroelectric layer 35 is formed on a sidewall of the first contact hole H1, and the second ferroelectric layer 36 is formed on a sidewall of the second contact hole H2.

Refer to FIG. 26D. The first conductive pillar 33 is formed on an inner side of the first ferroelectric layer 35, and the second conductive pillar 34 is formed on an inner side of the second ferroelectric layer 36.

In some examples, after the first stacked layer 30 is formed, the preparation method further includes the following steps.

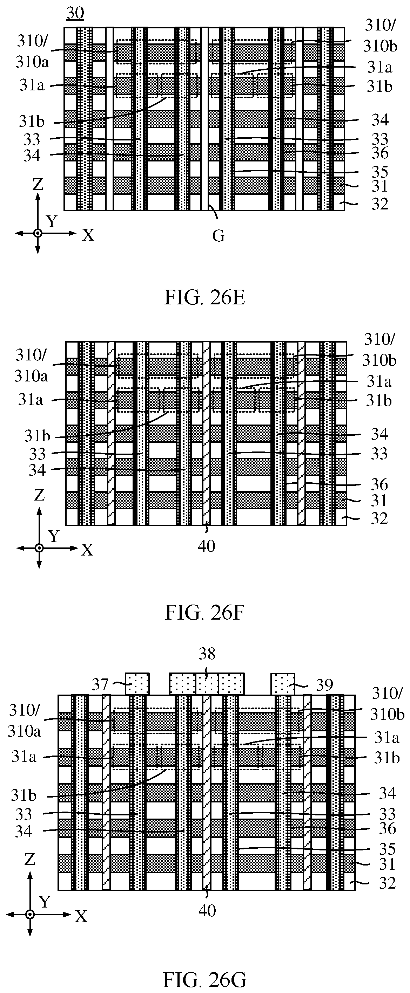

Refer to FIG. 26E. At least one isolation trench G that penetrates the first stacked layer 30 is formed. The at least one isolation trench G separates the conducting layer 31 into a plurality of conducting blocks 310, one conducting block 310 includes one first conductive portion 31a and one second conductive portion 31b, and the first conductive portion 31a is connected to the second conductive portion 31b.

Each conducting layer 31 includes a 1^{st} conducting block to an n^{th} conducting block that are sequentially disposed, n≥2, and n is a positive integer.

For example, refer to FIG. 26E. One conducting layer 31 includes the 1^{st} conducting block 310a and a 2^{nd} conducting block 310b that are sequentially disposed, that is, n=2.

Refer to FIG. 26F. A second dielectric layer 40 is formed in the isolation trench G.

In some examples, after the first conductive pillar 33 and the second conductive pillar 34 are formed, the preparation method further includes the following steps.

Refer to FIG. 26G. One first interconnection electrode 37, at least one second interconnection electrode 38, and one third interconnection electrode 39 are formed. The first interconnection electrode 37 is electrically connected to a first conductive pillar 33 that penetrates the 1^{st} conducting block. The second interconnection electrode 38 is electrically connected to a second conductive pillar 34 that penetrates an i^{th} conducting block and a first conductive pillar 33 that penetrates an (i+1)^{th} conducting block, i=1 to n-1, and i is a positive integer. The third interconnection electrode 39 is electrically connected to a second conductive pillar 34 that penetrates the n^{th} conducting block.

For example, refer to FIG. 26G. One conducting layer 31 includes the 1^{st} conducting block 310a and the 2^{nd} conducting block 310b that are sequentially disposed, that is, n=2. In this case, one second interconnection electrode 38 is formed.

The first interconnection electrode 37 is electrically connected to a first conductive pillar 33 that penetrates the 1^{st} conducting block 310a, the second interconnection electrode 38 is electrically connected to a second conductive pillar 34 that penetrates the 1^{st} conducting block 310a and a first conductive pillar 33 that penetrates the 2^{nd} conducting block 310b, and the third interconnection electrode 39 is electrically connected to a second conductive pillar 34 that penetrates the 2^{nd} conducting block 310b.

According to the preparation method provided in the foregoing embodiment of this application, the first stacked layer 30 is first formed. The first stacked layer 30 includes the plurality of conducting layers 31 and the plurality of first dielectric layers 32 that are alternately stacked. Then, the first contact hole H1 that penetrates the first conductive portion 31a and the second contact hole H2 that penetrates the second conductive portion 31b are formed. The first ferroelectric layer 35 and the first conductive pillar 33 are formed on the sidewall of the first contact hole H1, and the second ferroelectric layer 36 and the second conductive pillar 34 are formed on the sidewall of the second contact hole H2.

The first stacked layer 30 is etched to form the isolation trench G that penetrates the first stacked layer 30, and second dielectric layers 40 are formed in the isolation trench G to divide the conducting layer 31 into the plurality of conducting blocks 310, to increase a quantity of capacitors connected in series. An electric potential difference between two ends of each capacitor can be further reduced, to reduce a probability of polarization reversal at the ferroelectric layer of the capacitor, ensure a stable capacitance value of the capacitor, and improve an anti-interference capability of the capacitor.

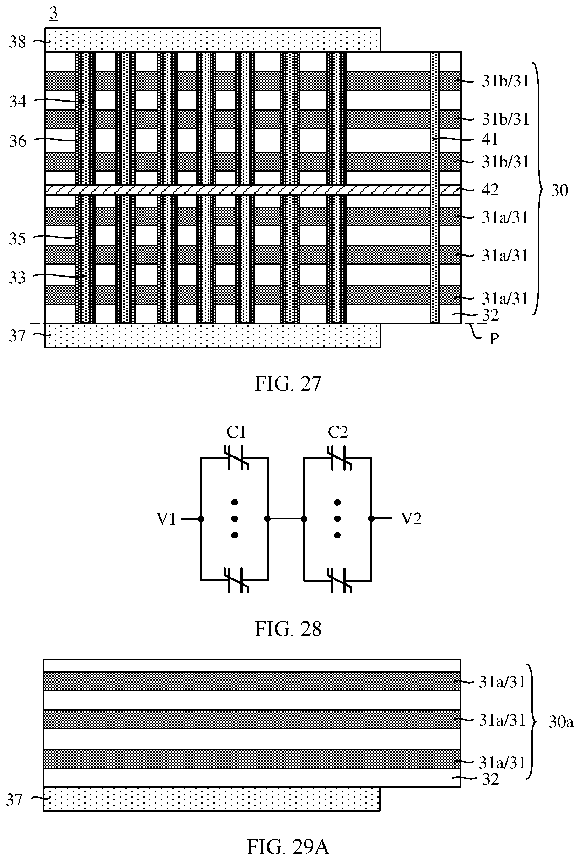

FIG. 27 is a cross-sectional view of still another capacitor according to some embodiments. FIG. 28 is an equivalent circuit schematic of the capacitor in FIG. 27.

In some embodiments, refer to FIG. 27. The plurality of conducting layers 31 include a plurality of first conductive portions 31a and a plurality of second conductive portions 31b, and the plurality of second conductive portions 31b are located on a side that is of the plurality of first conductive portions 31a and that is away from a bottom surface P of the first stacked layer 30.

For example, the plurality of first conductive portions 31a and the plurality of first dielectric layers 32 are alternately stacked, and the plurality of second conductive portions 31b and the plurality of first dielectric layers 32 are alternately stacked.

Refer to FIG. 27 and FIG. 28. The plurality of first conductive pillars 33 penetrate the plurality of first conductive portions 31a, which is equivalent to the plurality of first capacitors C1 being disposed in parallel. The plurality of second conductive pillars 34 penetrate the plurality of second conductive portions 31b, which is equivalent to the plurality of second capacitors C2 being disposed in parallel.

On this basis, the capacitor 3 further includes a third conductive pillar 41 that penetrates the first stacked layer 30, and the third conductive pillar 41 is electrically connected to the plurality of first conductive portions 31a and the plurality of second conductive portions 31b, so that the plurality of first capacitors C1 connected in parallel are connected in series to the plurality of second capacitors C2 connected in parallel.

In the foregoing embodiment of this application, a total capacitance value of the plurality of first capacitors C1 connected in parallel is greater than a capacitance value of one first capacitor C1, and a total capacitance value of the plurality of second capacitors C2 connected in parallel is greater than a capacitance value of one second capacitor C2. A total capacitance value of the capacitor 3 can be increased.

In addition, the plurality of first capacitors C1 connected in parallel are connected in series to the plurality of second capacitors C2 connected in parallel, thereby reducing an electric potential difference between two ends of the plurality of capacitors (the first capacitors C1 or the second capacitors C2) connected in parallel, and reducing the electric potential difference between the two ends of each capacitor, to reduce the probability of the polarization reversal at the ferroelectric layer of the capacitor, ensure the stable capacitance value of the capacitor, and improve the anti-interference capability of the capacitor.

In some embodiments, refer to FIG. 27. The capacitor 3 further includes the first interconnection electrode 37 and the second interconnection electrode 38. The first interconnection electrode 37 is disposed on a side that is of the bottom surface P of the first stacked layer 30 and that is away from the plurality of first conductive portions 31a. In other words, the first interconnection electrode 37 is disposed at the bottom of the first stacked layer 30. The first interconnection electrode 37 is electrically connected to end portions of the plurality of first conductive pillars 33, to transmit an electrical signal to the plurality of first conductive pillars 33 via the first interconnection electrode 37.

The second interconnection electrode 38 is disposed on a side that is of the plurality of second conductive portions 31b and that is away from the bottom surface P of the first stacked layer 30. In other words, the second interconnection electrode 38 is disposed on the top of the first stacked layer 30. The second interconnection electrode 38 is electrically connected to end portions of the plurality of second conductive pillars 34, to transmit an electrical signal to the plurality of second conductive pillars 34 via the second interconnection electrode 38.

Some embodiments of this application further provide a preparation method for a capacitor. FIG. 29A to FIG. 29K are diagrams of steps for preparing still another capacitor according to some embodiments. The preparation method includes the following steps.

Refer to FIG. 29A. A first stacked sublayer 30a is formed. The first stacked sublayer 30a includes the plurality of first conductive portions 31a and the plurality of first dielectric layers 32 that are alternately stacked.

In some examples, before the first stacked sublayer 30a is formed, the first interconnection electrode 37 is formed, and the first interconnection electrode 37 is located at the bottom of the first stacked sublayer 30a.

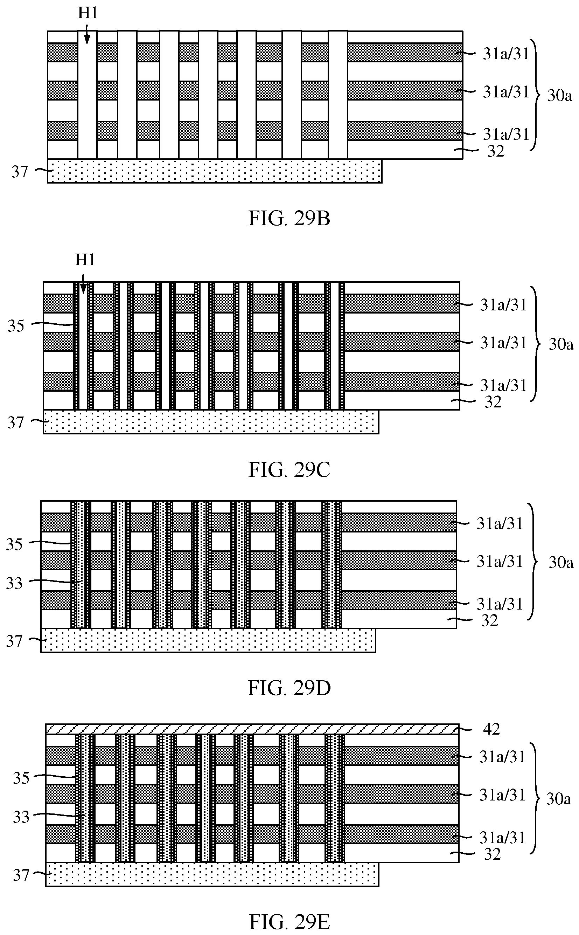

Refer to FIG. 29B. The first contact hole H1 that penetrates the plurality of first conductive portions 31a are formed.

Refer to FIG. 29C. The first ferroelectric layer 35 is formed on a sidewall of the first contact hole H1.

Refer to FIG. 29D. The first conductive pillar 33 is formed on an inner side of the first ferroelectric layer 35.

Refer to FIG. 29E. An insulation layer 42 is formed. The insulation layer 42 covers the first stacked sublayer 30a, the first ferroelectric layer 35, and the first conductive pillar 33.

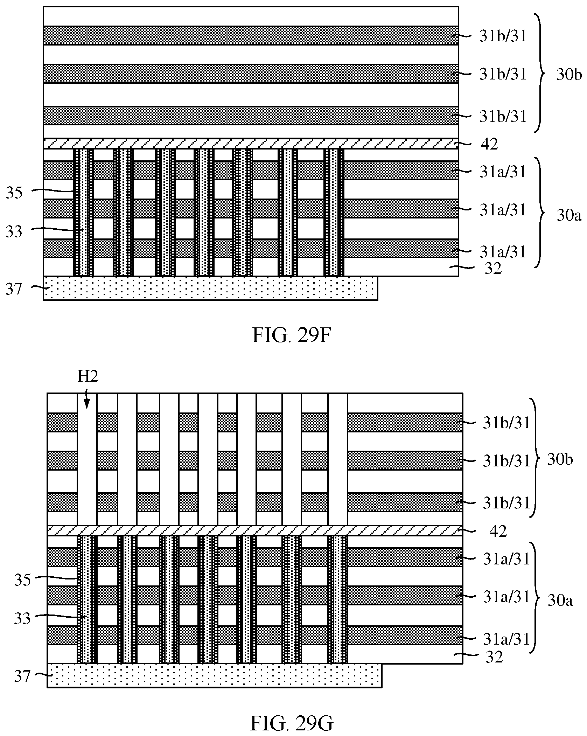

Refer to FIG. 29F. A second stacked sublayer 30b is formed on a side that is of the insulation layer 42 and that is away from the first stacked sublayer 30a. The second stacked sublayer 30b includes the plurality of second conductive portions 31b and the plurality of first dielectric layers 32 that are alternately stacked.

Refer to FIG. 29G. The second contact hole H2 that penetrates the plurality of second conductive portions 31b are formed.

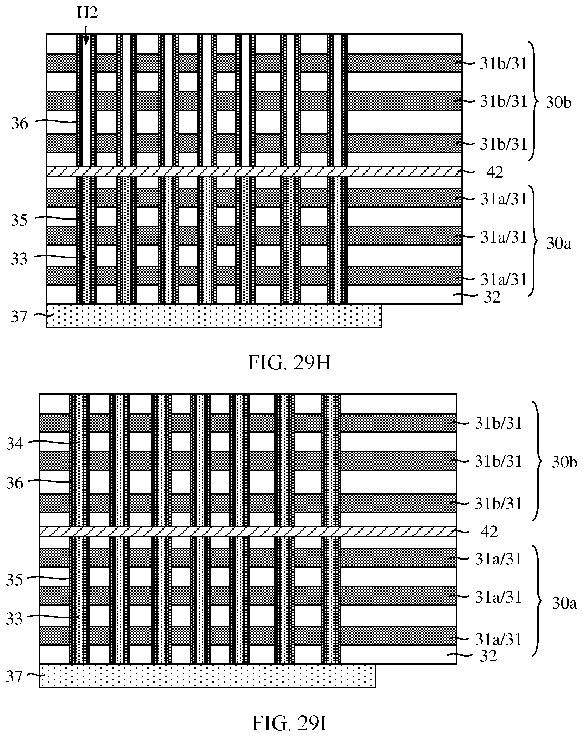

Refer to FIG. 29H. The second ferroelectric layer 36 is formed on a sidewall of the second contact hole H2.

Refer to FIG. 29I. The second conductive pillar 34 is formed on an inner side of the second ferroelectric layer 36.

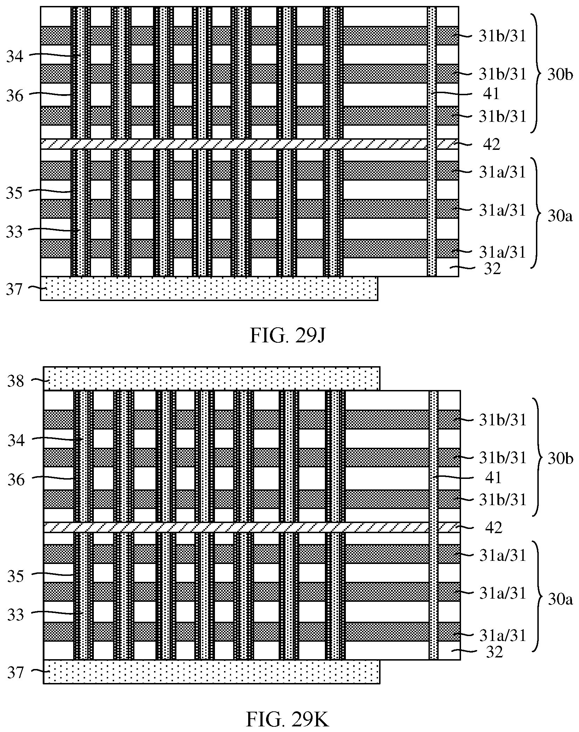

Refer to FIG. 29J. The third conductive pillar 41 is formed. The third conductive pillar 41 penetrates the second stacked sublayer 30b, the insulation layer 42, and the first stacked sublayer 30a, and is electrically connected to the plurality of first conductive portions 31a and the plurality of second conductive portions 31b.

In some examples, refer to FIG. 29K. After the third conductive pillar 41 is formed, the second interconnection electrode 38 is formed, and is located on the top of the second stacked sublayer 30b.

According to the preparation method provided in the foregoing embodiment of this application, the first stacked sublayer 30a is first formed. The first stacked sublayer 30a includes the plurality of first conductive portions 31a and the plurality of first dielectric layers 32 that are alternately stacked. Then, the first contact hole H1 that penetrates the plurality of first conductive portions 31a is formed, and the first ferroelectric layer 35 and the first conductive pillar 33 are formed on the sidewall of the first contact hole H1.

The second stacked sublayer 30b is formed above the first stacked sublayer 30a. The second stacked sublayer 30b includes the plurality of second conductive portions 31b and the plurality of first dielectric layers 32 that are alternately stacked. Then, the second contact hole H2 that penetrates the plurality of second conductive portions 31b is formed, and the second ferroelectric layer 36 and the second conductive pillar 34 are formed on the sidewall of the second contact hole H2.

Finally, the third conductive pillar 41 that penetrates the second stacked sublayer 30b and the first stacked sublayer 30a is formed, and is electrically connected to the plurality of first conductive portions 31a and the plurality of second conductive portions 31b, so that the plurality of first capacitors C1 connected in parallel are connected in series to the plurality of second capacitors C2 connected in parallel. An electric potential difference between two ends of each capacitor can be reduced, to reduce a probability of polarization reversal at the ferroelectric layer of the capacitor, ensure a stable capacitance value of the capacitor, and improve an anti-interference capability of the capacitor.

In the foregoing embodiments of this application, materials of the conducting layer 31, the first conductive pillar 33, and the second conductive pillar 34 include at least one of Ti, Au, W, Mo, Al, Cu, Ru, Ag, TiN, and ITO. In other words, the materials of the conducting layer 31, the first conductive pillar 33, and the second conductive pillar 34 may include one or more of these materials.

A material of the first ferroelectric layer 35 includes at least one of ZrO₂, HfO₂, HfAlO, HfSiO, HfZrO, HfLaO, and HfYO, that is, may include one or more of these materials. A material of the second ferroelectric layer 36 includes at least one of ZrO₂, HfO₂, HfAlO, HfSiO, HfZrO, HfLaO, and HfYO, that is, may include one or more of these materials.

The first dielectric layer 32 is of a single-layer structure or a stacked-layer structure. A material of the first dielectric layer 32 includes at least one of SiO₂, Al₂O₃, HfO₂, ZrO₂, TiO₂, Y₂O₃, and Si₃N₄, that is, may include one or more of these materials.

The ferroelectric memory, the three-dimensional integrated circuit, and the electronic device provided in some embodiments of this application include the capacitor provided in any one of the foregoing embodiments. For beneficial effect that can be achieved by the ferroelectric memory, the three-dimensional integrated circuit, and the electronic device, refer to beneficial effect of the capacitor described above. Details are not described herein again.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A ferroelectric memory, comprising an array region and a routing region, wherein the ferroelectric memory comprises a memory array disposed in the array region and a capacitor disposed in the routing region; and
the capacitor comprises:
a first stacked layer, comprising a plurality of conducting layers and a plurality of first dielectric layers that are alternately stacked, wherein the plurality of conducting layers comprise a first conductive portion and a second conductive portion that are connected;
a first conductive pillar and a second conductive pillar, wherein the first conductive pillar penetrates the first conductive portion, and the second conductive pillar penetrates the second conductive portion; and
a first ferroelectric layer and a second ferroelectric layer, wherein the first ferroelectric layer and the second ferroelectric layer are of cylindrical structures, the first ferroelectric layer penetrates the first conductive portion and is disposed around the first conductive pillar, and the second ferroelectric layer penetrates the second conductive portion and is disposed around the second conductive pillar, wherein
the capacitor comprises a first capacitor and a second capacitor that are disposed in series, the first capacitor comprises the first conductive pillar, the first ferroelectric layer, and the first conductive portion, and the second capacitor comprises the second conductive pillar, the second ferroelectric layer, and the second conductive portion.

2. The ferroelectric memory according to claim 1, wherein each conducting layer comprises at least one first conductive portion and at least one second conductive portion, and the first conductive portion and the second conductive portion that are connected are located at a same conducting layer.

3. The ferroelectric memory according to claim 2, wherein each conducting layer comprises one first conductive portion and one second conductive portion, and the first conductive portion is connected to the second conductive portion;
the first conductive portion and the second conductive portion are arranged in a first direction, and the first direction is parallel to a bottom surface of the first stacked layer; and
a plurality of first conductive pillars penetrate the first conductive portion, and the plurality of second conductive pillars penetrate the second conductive portion.

4. The ferroelectric memory according to claim 3, wherein the capacitor further comprises a first interconnection electrode and a second interconnection electrode, and the first interconnection electrode and the second interconnection electrode are of planar structures;
the first interconnection electrode and the second interconnection electrode are arranged in the first direction; and
the first interconnection electrode is electrically connected to end portions of the plurality of first conductive pillars, and the second interconnection electrode is electrically connected to end portions of the plurality of second conductive pillars.

5. The ferroelectric memory according to claim 3 or 4, wherein the plurality of first conductive pillars are arranged in an array, and/or the plurality of second conductive pillars are arranged in an array.

6. The ferroelectric memory according to claim 3, wherein the capacitor further comprises a first interconnection electrode and a second interconnection electrode, and the first interconnection electrode and the second interconnection electrode are of comb structures;
the first interconnection electrode and the second interconnection electrode are arranged in the first direction, the first interconnection electrode comprises a plurality of first interconnection lines, and the second interconnection electrode comprises a plurality of second interconnection lines; and
the first interconnection line and the second interconnection line extend in the first direction, the plurality of first interconnection lines are electrically connected to end portions of the plurality of first conductive pillars, the plurality of first interconnection lines are connected to one side of the first stacked layer in the first direction, the plurality of second interconnection lines are electrically connected to end portions of the plurality of second conductive pillars, and the plurality of second interconnection lines are connected to the other side of the first stacked layer in the first direction; or
the first interconnection line and the second interconnection line extend in a second direction, the plurality of first interconnection lines are electrically connected to end portions of the plurality of first conductive pillars, the plurality of first interconnection lines are connected to one side of the first stacked layer in the second direction, the plurality of second interconnection lines are electrically connected to end portions of the plurality of second conductive pillars, the plurality of second interconnection lines are connected to the other side of the first stacked layer in the second direction, and the second direction is parallel to the bottom surface of the first stacked layer and intersects with the first direction.

7. The ferroelectric memory according to claim 2, wherein each conducting layer comprises a plurality of first conductive portions and a plurality of second conductive portions, and the plurality of first conductive portions are connected to the plurality of second conductive portions;
the first conductive portions and the second conductive portions are alternately arranged in a first direction, and the first direction is parallel to a bottom surface of the first stacked layer; and
the plurality of first conductive pillars penetrate the first conductive portions, and the plurality of second conductive pillars penetrate the second conductive portions.

8. The ferroelectric memory according to claim 7, wherein the capacitor further comprises a first interconnection electrode and a second interconnection electrode, and the first interconnection electrode and the second interconnection electrode are of comb structures;
the first interconnection electrode comprises a plurality of first interconnection lines, the second interconnection electrode comprises a plurality of second interconnection lines, the plurality of first interconnection lines and the plurality of second interconnection lines are arranged in the first direction, the first interconnection lines and the second interconnection lines extend in a second direction, and the second direction is parallel to the bottom surface of the first stacked layer and intersects with the first direction; and
the plurality of first interconnection lines are electrically connected to end portions of the plurality of first conductive pillars, the plurality of first interconnection lines are connected to one side of the first stacked layer in the second direction, the plurality of second interconnection lines are electrically connected to end portions of the plurality of second conductive pillars, and the plurality of second interconnection lines are connected to the other side of the first stacked layer in the second direction.

9. The ferroelectric memory according to claim 8, wherein the plurality of first interconnection lines and the plurality of second interconnection lines are alternately arranged in the first direction; or
there is no second interconnection line or there are a plurality of second interconnection lines disposed between two adjacent first interconnection lines, and there is no first interconnection line or there are a plurality of first interconnection lines disposed between two adjacent second interconnection lines.

10. The ferroelectric memory according to any one of claims 6, 8, and 9, wherein there are a plurality of rows of the plurality of first conductive pillars, and one first interconnection line is electrically connected to one row of first conductive pillars; and/or
there are a plurality of rows of the plurality of second conductive pillars, and one second interconnection line is electrically connected to one row of second conductive pillars.

11. The ferroelectric memory according to any one of claims 2 to 10, wherein the first conductive portion and the second conductive portion that are located at the same conducting layer are integrally disposed.

12. The ferroelectric memory according to claim 2, wherein each conducting layer comprises a plurality of spaced-apart conducting blocks, and one conducting block comprises one first conductive portion and one second conductive portion that are connected;
a plurality of first conductive pillars penetrate the first conductive portion of the conducting block, and a plurality of second conductive pillars penetrate the second conductive portion of the conducting block; and
in two adjacent conducting blocks, the plurality of second conductive pillars that penetrate one conducting block are electrically connected to the plurality of first conductive pillars that penetrate the other conducting block.

13. The ferroelectric memory according to claim 12, wherein the capacitor further comprises a second dielectric layer that penetrates the first stacked layer and separates the two adjacent conducting blocks.

14. The ferroelectric memory according to claim 12 or 13, wherein each conducting layer comprises a 1^{st} conducting block to an n^{th} conducting block that are sequentially disposed, n≥2, and n is a positive integer; and
the capacitor further comprises one first interconnection electrode, at least one second interconnection electrode, and one third interconnection electrode; the first interconnection electrode is electrically connected to a first conductive pillar that penetrates the 1^{st} conducting block, the second interconnection electrode is electrically connected to a second conductive pillar that penetrates an i^{th} conducting block and a first conductive pillar that penetrates an (i+1)^{th} conducting block, i=1 to n-1, and i is a positive integer; and the third interconnection electrode is electrically connected to a second conductive pillar that penetrates the n^{th} conducting block.

15. The ferroelectric memory according to claim 1, wherein the plurality of conducting layers comprise a plurality of first conductive portions and a plurality of second conductive portions, and the plurality of second conductive portions are located on a side that is of the plurality of first conductive portions and that is away from a bottom surface of the first stacked layer;
the plurality of first conductive pillars penetrate the plurality of first conductive portions, and the plurality of second conductive pillars penetrate the plurality of second conductive portions; and
the capacitor further comprises a third conductive pillar that penetrates the first stacked layer, and the third conductive pillar is electrically connected to the plurality of first conductive portions and the plurality of second conductive portions.

16. The ferroelectric memory according to claim 15, wherein the capacitor further comprises a first interconnection electrode and a second interconnection electrode;
the first interconnection electrode is disposed on a side that is of the bottom surface of the first stacked layer and that is away from the plurality of first conductive portions, and is electrically connected to end portions of the plurality of first conductive pillars; and
the second interconnection electrode is disposed on a side that is of the plurality of second conductive portions and that is away from the bottom surface of the first stacked layer, and is electrically connected to end portions of the plurality of second conductive pillars.

17. The ferroelectric memory according to any one of claims 1 to 16, wherein materials of the conducting layer, the first conductive pillar, and the second conductive pillar comprise at least one of Ti, Au, W, Mo, Al, Cu, Ru, Ag, TiN, and ITO.

18. The ferroelectric memory according to any one of claims 1 to 17, wherein materials of the first ferroelectric layer and/or the second ferroelectric layer comprise at least one of ZrO₂, HfO₂, HfAlO, HfSiO, HfZrO, HfLaO, and HfYO.

19. The ferroelectric memory according to any one of claims 1 to 18, wherein the first dielectric layer is of a single-layer structure or a stacked-layer structure; and
a material of the first dielectric layer comprises at least one of SiO₂, Al₂O₃, HfO₂, ZrO₂, TiO₂, Y₂O₃, and Si₃N₄.

20. The ferroelectric memory according to any one of claims 1 to 19, wherein the memory array comprises a second stacked layer, and the second stacked layer comprises a plurality of memory cells arranged in an array; and
the second stacked layer comprises third dielectric layers and gate layers that are alternately disposed, the plurality of first dielectric layers of the first stacked layer one-to-one correspond to the plurality of third dielectric layers of the second stacked layer, and the first dielectric layer and the third dielectric layer that correspond to each other have a same material and are disposed at a same layer; and the plurality of conducting layers of the first stacked layer one-to-one correspond to the plurality of gate layers of the second stacked layer, and the conducting layer and the gate layer that correspond to each other have a same material are disposed at a same layer, and are insulated from each other.

21. A preparation method for a ferroelectric memory, comprising:
forming a first stacked layer, wherein the first stacked layer comprises a plurality of conducting layers and a plurality of first dielectric layers that are alternately stacked, and the plurality of conducting layers comprise a first conductive portion and a second conductive portion that are connected;
forming a first contact hole that penetrates the first conductive portion and a second contact hole that penetrates the second conductive portion;
forming a first ferroelectric layer on a sidewall of the first contact hole, and forming a second ferroelectric layer on a sidewall of the second contact hole; and
forming a first conductive pillar on an inner side of the first ferroelectric layer, and forming a second conductive pillar on an inner side of the second ferroelectric layer.

22. The preparation method according to claim 21, wherein after the forming a first conductive pillar and a second conductive pillar, the method further comprises:
forming a first interconnection electrode and a second interconnection electrode, wherein the first interconnection electrode is electrically connected to end portions of a plurality of first conductive pillars, and the second interconnection electrode is electrically connected to end portions of a plurality of second conductive pillars.

23. The preparation method according to claim 21, wherein after the forming a first stacked layer, the method further comprises:
forming at least one isolation trench that penetrates the first stacked layer, wherein the at least one isolation trench separates the conducting layer into a plurality of conducting blocks, one conducting block comprises one first conductive portion and one second conductive portion, and the first conductive portion is connected to the second conductive portion; and
forming a second dielectric layer in the isolation trench.

24. The preparation method according to claim 23, wherein each conducting layer comprises a 1^{st} conducting block to an n^{th} conducting block that are sequentially disposed, n≥2, and n is a positive integer; and
after the forming a first conductive pillar and a second conductive pillar, the method further comprises:
forming one first interconnection electrode, at least one second interconnection electrode, and one third interconnection electrode, wherein the first interconnection electrode is electrically connected to a first conductive pillar that penetrates the 1^{st} conducting block, the second interconnection electrode is electrically connected to a second conductive pillar that penetrates an i^{th} conducting block and a first conductive pillar that penetrates an (i+1)^{th} conducting block, i=1 to n-1, and i is a positive integer; and the third interconnection electrode is electrically connected to a second conductive pillar that penetrates the n^{th} conducting block.

25. The preparation method according to any one of claims 21 to 24, wherein the ferroelectric memory comprises an array region and a routing region; and
a second stacked layer is synchronously formed in the array region in a process of forming the first stacked layer in the routing region.

26. A preparation method for a ferroelectric memory, comprising:
forming a first stacked sublayer, wherein the first stacked sublayer comprises a plurality of first conductive portions and a plurality of first dielectric layers that are alternately stacked;
forming a first contact hole that penetrates the plurality of first conductive portions;
forming a first ferroelectric layer on a sidewall of the first contact hole;
forming a first conductive pillar on an inner side of the first ferroelectric layer;
forming an insulation layer, wherein the insulation layer covers the first stacked sublayer, the first ferroelectric layer, and the first conductive pillar;
forming a second stacked sublayer on a side that is of the insulation layer and that is away from the first stacked sublayer, wherein the second stacked sublayer comprises a plurality of second conductive portions and a plurality of first dielectric layers that are alternately stacked;
forming a second contact hole that penetrates the plurality of second conductive portions;
forming a second ferroelectric layer on a sidewall of the second contact hole;
forming a second conductive pillar on an inner side of the second ferroelectric layer; and
forming a third conductive pillar, wherein the third conductive pillar penetrates the second stacked sublayer, the insulation layer, and the first stacked sublayer, and is electrically connected to the plurality of first conductive portions and the plurality of second conductive portions.

27. A three-dimensional integrated circuit, comprising:
the ferroelectric memory according to any one of claims 1 to 20; and
a processor chip, stacked with the ferroelectric memory, and electrically connected to the ferroelectric memory.

28. An electronic device, comprising:
a circuit board; and
the ferroelectric memory according to any one of claims 1 to 20 or the three-dimensional integrated circuit according to claim 27, disposed on the circuit board and electrically connected to the circuit board.
